# EUROPEAN PATENT APPLICATION

(11) **EP 4 451 329 A1**
(43) Date of publication of application: **23.10.2024**
(21) Application number: 22908038.7
(22) Date of filing: 19.12.2022
(51) Int. Cl.: H01L 25/075, H01L 33/48, H01L 33/50, H01L 33/54, H01L 33/36, H01L 33/22, H01L 33/46, H01L 33/62

(54) **LIGHT EMITTING ELEMENT AND LIGHT EMITTING MODULE**

(30) Priority: 19.12.2021 US 202163291448 P; 21.12.2021 US 202163292072 P; 23.12.2021 US 202163293628 P; 16.12.2022 US 202218083212
(71) Applicant: Seoul Viosys Co., Ltd., Ansan-si, Gyeonggi-do 15429 (KR)
(72) Inventor: LEE, Seom Geun, Ansan-Si Gyeonggi-do 15429 (KR); PARK, Ki Ho, Ansan-Si Gyeonggi-do 15429 (KR); JANG, Jong Min, Ansan-Si Gyeonggi-do 15429 (KR); KIM, Chae Hon, Ansan-Si Gyeonggi-do 15429 (KR); KIM, Sang Min, Ansan-Si Gyeonggi-do 15429 (KR)
(74) Representative: Stolmár & Partner Patentanwälte PartG mbB
(86) International application number: PCT/KR2022/020714
(87) International publication number: WO 2023/113574

(57) **Abstract**

A light emitting device and a light emitting module including the same are disclosed. The light emitting module may include: a circuit board; a plurality of light emitting devices disposed on the circuit board and emitting UV light; a plurality of wavelength conversion portions each disposed on a light emission surface of the light emitting device emitting UV light and converting a wavelength of light emitted from the light emitting device; and a molding portion covering the light emitting devices and the wavelength conversion portions formed on the circuit board. Each of the light emitting devices may include a first semiconductor layer, a second semiconductor layer, and an active layer disposed between the first semiconductor layer and the second semiconductor layer. One surface of the first semiconductor layer may correspond to the light emission surface of the light emitting device. In addition, at least one of the wavelength conversion portions may convert light emitted from the light emitting device into light having a different color than light converted by another wavelength conversion portion.

## Description

### [Technical Field]

The present invention relates to a light emitting device and a light emitting module including the light emitting device.

### [Background Art]

A light emitting diode is an inorganic semiconductor device that emits light generated through recombination of electrons and holes. In particular, ultraviolet (UV) light emitting diodes are used in various fields, such as UV curing, sterilization, white light sources, display light sources, pharmaceuticals, equipment parts, and the like.

The UV light emitting diode emits light having a relatively short peak wavelength (typically light having a peak wavelength of 400 nm or less). In manufacture of such an ultraviolet light emitting diode, an active layer is formed of a material having a bandgap energy corresponding to a relatively short peak wavelength. For example, the active layer may be formed of AlGaN containing 10% or more of Al as a nitride semiconductor. In addition, when the n-type and p-type nitride semiconductor layers have lower bandgap energy than ultraviolet light emitted from the active layer, UV light emitted from the active layer can be absorbed by the n-type and p-type nitride semiconductor layers. The nitride semiconductor layers of the light emitting diode. Thus, not only the active layer of the UV light emitting diode but also other semiconductor layers disposed in a light emitting direction of the light emitting diode have an Al content of 10% or more.

In recent years, in order to reduce the thickness of a display apparatus in which light emitting diodes are mounted, a light emitting diode (micro-LED) having horizontal and vertical lengths of 100 µm or less is applied thereto.

### [Disclosure]

### [Technical Problem]

It is an objective of the present invention to provide a light emitting device corresponding to a micro-LED and a light emitting module including the light emitting device.

It is another objective of the present invention to provide a light emitting device having improved luminous efficacy and a light emitting module including the light emitting device.

### [Technical Solution]

A light emitting module according to one embodiment of the present invention includes: a circuit board; a plurality of light emitting devices disposed on the circuit board and emitting UV light; a plurality of wavelength conversion portions each disposed on a light exit surface of the light emitting device emitting UV light and converting a wavelength of light emitted from the light emitting device; and a molding portion covering the light emitting devices and the wavelength conversion portions formed on the circuit board. Each of the light emitting devices may include a first semiconductor layer, a second semiconductor layer, and an active layer disposed between the first semiconductor layer and the second semiconductor layer. One surface of the first semiconductor layer may correspond to the light exit surface of the light emitting device. In addition, at least one of the wavelength conversion portions may convert light emitted from the light emitting device into light having a different color than light converted by another wavelength conversion portion.

The light emitting device may include a first electrode electrically connected to the first semiconductor layer and a second electrode electrically connected to the second semiconductor layer, wherein the first electrode and the second electrode may be disposed to face the circuit board.

The first electrode and the second electrode of the light emitting device may be electrically connected to the circuit board.

The wavelength conversion portion may contact the first semiconductor layer of the light emitting device.

The light emitting device may include an electrode electrically connected to the second semiconductor layer. In addition, the electrode may be disposed to face the circuit board.

The light emitting module may include an electrode disposed between the light emitting devices and the wavelength conversion portions.

The electrode of the light emitting device may be electrically connected to the circuit board and the first semiconductor layer of the light emitting device may be electrically connected to the electrode.

The molding portion may have a flat upper surface. Here, the upper surface of the molding layer may have a periphery flush with a periphery of an upper surface of each of the wavelength conversion portions.

The molding portion may have a convex or concave upper surface. Here, the upper surface of the molding layer may have a periphery flush with a periphery of an upper surface of each of the wavelength conversion portions.

The molding portion may include a first molding portion covering side surfaces of the light emitting devices and a second molding portion covering side surfaces of the wavelength conversion portions.

Each of the first molding portion and the second molding portion may have a flat upper surface.

The upper surface of the first molding portion may have a periphery flush with a periphery of an upper surface of each of the light emitting devices and the upper surface of the second molding portion may have a periphery flush with a periphery of an upper surface of each of the wavelength conversion portions.

Each of the first molding portion and the second molding portion may have a convex or concave upper surface. Here, the upper surface of the first molding portion may have a periphery flush with a periphery of an upper surface of each of the light emitting devices. In addition, the upper surface of the second molding portion may have a periphery flush with a periphery of an upper surface of each of the wavelength conversion portions.

The plurality of wavelength conversion portions may include a first wavelength conversion portion converting the light emitted from the light emitting device into red light, a second wavelength conversion portion converting the light emitted from the light emitting device into green light, and a third wavelength conversion portion converting the light emitted from the light emitting device into blue light.

The light emitting module may include a light emitting portion including the light emitting device and the wavelength conversion portions. The light emitting portion may include a first light emitting portion including the first wavelength conversion portion, a second light emitting portion including the second wavelength conversion portion, and a third light emitting portion including the third wavelength conversion portion.

The light emitting module may include a dummy portion including the light emitting device and free from the wavelength conversion portion.

The second semiconductor layer of the light emitting device may have one surface and the other surface connected to the one surface and perpendicular thereto. Here, the one surface of the second semiconductor layer may face in an opposite direction to the light exit surface.

The second semiconductor layer of the light emitting device may have one surface and the other surface connected to the one surface at an obtuse angle. Here, the one surface of the second semiconductor layer may face in an opposite direction to the light exit surface.

The light exit surface of the light emitting device may have a roughness structure.

The light emitting device may further include a material layer covering at least part of one surface of the second semiconductor layer. In addition, the material layer may be formed of a light reflective material or a light transmissive layer.

The light emitting device may have a cross-sectional area of 30 µm x 30 µm or less.

### [Advantageous Effects]

The light emitting devices according to embodiments of the present invention are suitable for minimization through omission of a growth substrate.

The light emitting device according to embodiments of the present invention can prevent light generated from the active layer and traveling towards the second semiconductor layer from being absorbed by the second semiconductor layer, and can reflect the light towards the light exit surface, thereby improving luminous efficacy of the light emitting device and the light emitting module.

It is to be understood that both the foregoing general description and the following detailed description are exemplary and explanatory and are intended to provide further explanation of the invention as claimed.

### [Description of Drawings]

The accompanying drawings, which are included to provide a further understanding of the invention and are incorporated in and constitute a part of this specification, illustrate exemplary embodiments of the invention, and together with the description serve to explain the inventive concepts.
FIG. 1 is a perspective view of a light emitting module according to a first embodiment of the present invention.
FIG. 2 to FIG. 5 are views illustrating a method of manufacturing the light emitting module according to the first embodiment of the present invention.
FIG. 6 is a sectional view of a light emitting module according to a second embodiment of the present invention.
FIG. 7 is a sectional view of a light emitting module according to a third embodiment of the present invention.
FIG. 8 is a sectional view of a light emitting module according to a fourth embodiment of the present invention.
FIG. 9 is a sectional view of a light emitting module according to a fifth embodiment of the present invention.
FIG. 10 is a sectional view of a light emitting module according to a sixth embodiment of the present invention.
FIG. 11 is a perspective view of a light emitting module according to a seventh embodiment of the present invention.
FIG. 12 to FIG. 14 are views illustrating a method of manufacturing the light emitting module according to the seventh embodiment of the present invention.
FIG. 15 is a sectional view of a light emitting module according to an eighth embodiment of the present invention.
FIG. 16 is a sectional view of a light emitting module according to a ninth embodiment of the present invention.
FIG. 17 to FIG. 24 are views illustrating a method of manufacturing the light emitting module 1001 according to the ninth embodiment of the present invention.
FIG. 25 is a perspective view of a light emitting module according to an eleventh embodiment of the present invention.
FIG. 26 to FIG. 28 are views illustrating a method of manufacturing the light emitting module according to the eleventh embodiment of the present invention.
FIG. 29 is a sectional view according to a twelfth embodiment of the present invention.
FIG. 30 is a sectional view of a light emitting package according to a thirteenth embodiment of the present invention.
FIG. 31 is a view of a first embodiment of a pixel arrangement of a light emitting module according to the present invention.
FIG. 32 is a view of a second embodiment of the pixel arrangement of the light emitting module according to the present invention.
FIG. 33 is a view of a third embodiment of the pixel arrangement of the light emitting module according to the present invention.
FIG. 34 is a view of a fourth embodiment of the pixel arrangement of the light emitting module according to the present invention.
FIG. 35 is a plan view of a light emitting device according to a first embodiment of the present invention.
FIG. 36 is a sectional view of the light emitting device according to the first embodiment of the present invention.
FIG. 37 is a sectional view of a light emitting device according to a second embodiment of the present invention.
FIG. 38 is a sectional view of a light emitting device according to a third embodiment of the present invention.
FIG. 39 is a sectional view of a light emitting device according to a fourth embodiment of the present invention.
FIG. 40 is a sectional view of a light emitting device according to a fifth embodiment of the present invention.
FIG. 41 is a plan view of a light emitting device according to a sixth embodiment of the present invention.
FIG. 42 is a sectional view of the light emitting device according to the sixth embodiment of the present invention.
FIG. 43 is another sectional view of the light emitting device according to the sixth embodiment of the present invention.
FIG. 44 is an exemplary view of the light emitting devices according to the sixth embodiment of the present invention formed on a growth substrate.

### [Mode for Invention]

In the following description, for the purposes of explanation, numerous specific details are set forth in order to provide a thorough understanding of various exemplary embodiments or implementations of the invention. As used herein "embodiments" and "implementations" are interchangeable words that are non-limiting examples of devices or methods employing one or more of the inventive concepts disclosed herein. It is apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an exemplary embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, a light emitting device and a light emitting module according to the present invention will be described in detail with reference to the accompanying drawings.

A light emitting module according to embodiments of the present invention may be applied to a display apparatus. In addition, light emitting devices included in the light emitting module may be micro-LEDs. Details of the light emitting module will be described with reference to the accompanying drawings.

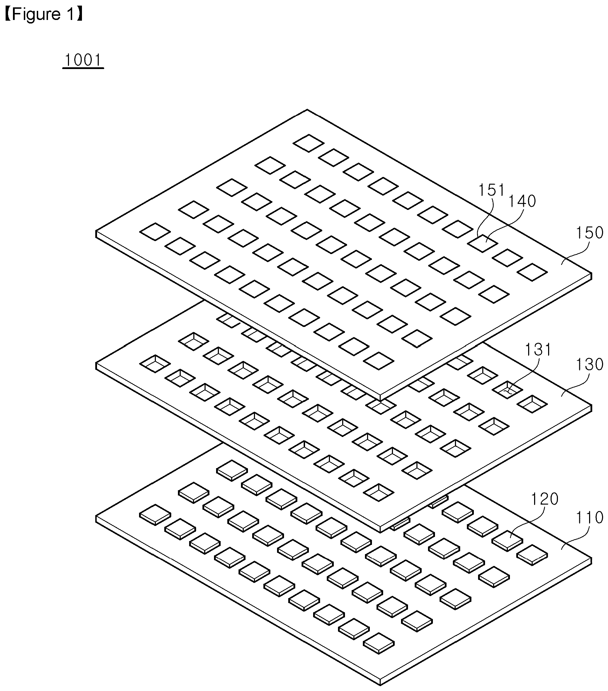

FIG. 1 to FIG. 5 are views of a light emitting module according to a first embodiment of the present invention.

FIG. 1 is a perspective view of the light emitting module according to the first embodiment of the present invention.

Referring to FIG. 1, the light emitting module 1001 according to the first embodiment includes a circuit board 110, a plurality of light emitting devices 120, a first molding portion 130, a plurality of wavelength conversion portions 140, and a second molding portion 150.

The plurality of light emitting devices 120 act as light sources of the light emitting module 1001 and may be disposed on the circuit board 110. In addition, the plurality of light emitting devices 120 may be individually operated. According to this embodiment, each of the light emitting devices 120 may be a light emitting diode having an n-type semiconductor layer disposed to face a light emission surface thereof. Accordingly, all electrodes of the light emitting device 120 may be disposed in the same direction. For example, the light emitting device 120 may emit UV light.

The first molding portion 130 may be disposed on the substrate, on which the plurality of light emitting devices 120 is disposed. The first molding portion 130 may include a plurality of first openings 131 exposing at least part of upper surfaces of the plurality of light emitting devices 120. The first openings 131 may be formed in the form of through-holes extending from an upper surface of the first molding portion 130 to a lower surface thereof or in the form of openings each surrounding a side surface of the light emitting device 120. The plurality of first openings 131 may be provided with the light emitting devices 120, respectively.

The second molding portion 150 may be disposed on the first molding portion 130. The second molding portion 150 may be formed with a plurality of second openings 151. The second openings 151 may be disposed on the first openings 131 of the first molding portion.

The second molding portion 150 may be formed of a different material than the first molding portion 130 or a material having different properties than the first molding portion 130, and an interface may be formed between the second molding portion 150 and the first molding portion 130, without being limited thereto. Alternatively, the first and second molding portions may be integrally formed with each other to form a single molding portion, the second molding portion 150 may be formed of the same material as the first molding portion 130, or the second molding portion 150 and the first molding portion 130 may be formed without an interface border therebetween. The second molding portion 150 and the first molding portion 130 may be formed at the same time through a single process, or the second molding portion 150 may be formed after formation of the first molding portion 130.

Each of the plurality of the second openings 151 of the second molding portion 150 may be provided with the wavelength conversion portion 140. Accordingly, the wavelength conversion portion 140 is provided in plural. In addition, the wavelength conversion portion 140 may be disposed on each of the light emitting devices 120. The wavelength conversion portion 140 may be provided in plural to be spaced apart from each other.

A window region in which the second opening 151 faces the light emitting device 120 may have a larger area than an upper surface of the light emitting device 120. Alternatively, the window region in which the second opening 151 faces the light emitting device 120 may have a greater width than the light emitting device 120. The window region may be formed over the upper surface of the light emitting device 120 and an upper surface of the first molding portion 130. Alternatively, an interface at which a side surface of the light emitting device 120 adjoins the first molding portion 130 may overlap the window region. Accordingly, the quantity of light entering the window increases, improving light conversion efficiency, and thereby implementing a light emitting module with improved clarity.

In another embodiment, the window region in which the second opening 151 faces the light emitting device 120 may have a smaller area than the upper surface of the light emitting device 120. Alternatively, the window region in which the second opening 151 faces the light emitting device 120 may have a smaller width than the light emitting device 120. The window region may be formed on the upper surface of the light emitting device 120. Additionally, the second molding portion 150 may be formed over the upper surface of the light emitting device 120 and the upper surface of the first molding portion 130. Alternatively, the interface at which the side surface of the light emitting device 120 adjoins the first molding portion 130 may overlap the second molding portion 150. Accordingly, a distance between the wavelength conversion portions 140 becomes greater than a distance between the light emitting devices 120, thereby implementing a light emitting module with improved color contrast ratio.

Accordingly, light emitted from each of the light emitting devices 120 may be emitted from the light emitting module 1001 after passing through the wavelength conversion portion 140 disposed on the corresponding light emitting device. At least some fraction of light passing through the wavelength conversion portion 140 may be converted into light in a different wavelength band than the light emitted from the light emitting device 120 by the wavelength conversion portion 140. The light subjected to wavelength conversion by the wavelength conversion portion 140 has a peak wavelength in a different wavelength band than the light emitted from the light emitting device 120. That is, the light subjected to wavelength conversion by the wavelength conversion portion 140 has a different color than the light emitted from the light emitting device 120. At least two wavelength conversion portions 140 may contain different kinds of wavelength conversion materials. Alternatively, a difference in peak wavelength of light subjected to wavelength conversion by at least two wavelength conversion portions 140 may be 50 nm or more.

A difference in peak wavelength of light generated from at least two light emitting devices 120 may be 10 nm or less, or may be adjusted within 5% with reference to a certain wavelength to improve uniformity of light among the light emitting devices.

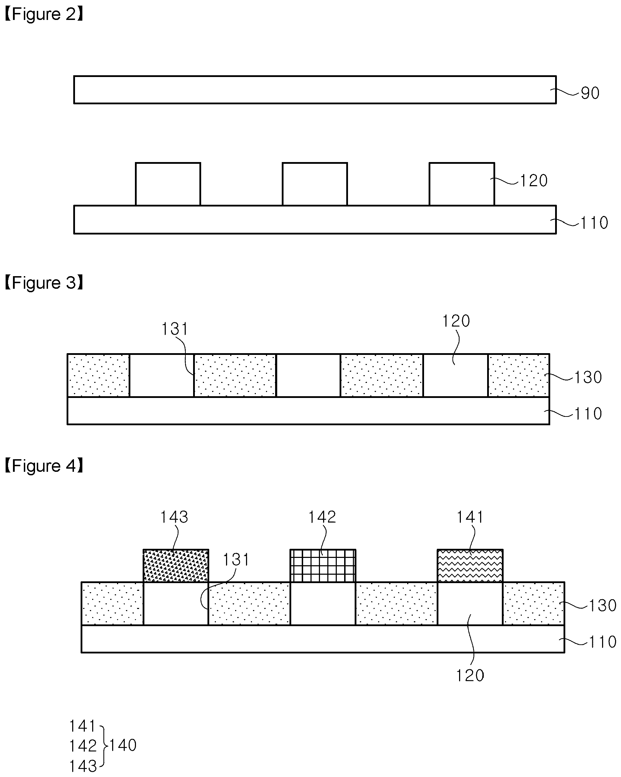

FIG. 2 to FIG. 5 are views illustrating a method of manufacturing the light emitting module according to the first embodiment of the present invention.

The method of manufacturing the light emitting module 1001 will be described with reference to a cross-section of some region of the light emitting module 1001. That is, although three light emitting devices 120 are shown in the drawings illustrating the method of manufacturing the light emitting module 1001, other implementations are possible. That is, the manufacturing method according to the present invention may be applied to the entirety or some of a plurality of light emitting devices 120 formed on a growth substrate 90 or to the entirety or some of a plurality of light emitting devices 120 mounted on a circuit board 110.

Referring to FIG. 2, the plurality of light emitting devices 120 may be mounted on the circuit board 110.

Each of the light emitting devices 120 may be a light emitting diode grown on the growth substrate 90. For example, the growth substrate 90 may be a sapphire substrate.

The light emitting device 120 may include a semiconductor structure including nitride semiconductor layers grown on the growth substrate 90 and electrodes electrically connected to the semiconductor structure. The light emitting device 120 according to this embodiment may have a structure in which an n-type semiconductor layer is disposed to face a light emission surface. Thus, in the semiconductor structure, both an n-type electrode connected to the n-type semiconductor layer and a p-type electrode connected to a p-type semiconductor layer may be disposed in the same direction. With reference to the semiconductor structure on the growth substrate 90, both the first electrode and the second electrode may be disposed on the semiconductor structure. Alternatively, for the light emitting device 120 mounted on the circuit board 110, both the first electrode and the second electrode may be disposed under the semiconductor structure.

In addition, the light emitting device 120 applied to the light emitting module 1001 according to this embodiment may be a micro-LED. That is, the width and length of a cross-sectional area of the light emitting device 120 may each be 100 µm or less. Alternatively, the light emitting device 120 may have a cross-sectional area of 30 µm x 30 µm or less. Alternatively, the light emitting device 120 may have a cross-sectional area of 10 µm x 10 µm or less. Alternatively, the light emitting device 120 may have a cross-sectional area of 30 µm x 30 µm or less. Alternatively, the light emitting device 120 may have a cross-sectional area of 10 µm x 10 µm or less.

According to this embodiment, the plurality of light emitting devices 120 may be formed in an array on the growth substrate 90. In addition, the light emitting device 120 according to this embodiment may generate and emit UV light.

After the plurality of light emitting devices 120 formed on the growth substrate 90 is mounted on the circuit board 110, the growth substrate 90 may be removed therefrom. When the growth substrate 90 is removed from the light emitting devices 120, the nitride semiconductor layer included in the semiconductor structure of the light emitting devices 120 can be exposed to the outside.

The circuit board 110 may include a circuit pattern, which is a wire for supplying electricity to the light emitting device 120. When the light emitting devices 120 are mounted on the circuit board 110, the light emitting devices 120 may be electrically connected to the circuit pattern. That is, the electrodes of the light emitting devices 120 may be electrically connected to the circuit pattern. Alternatively, the electrodes of the light emitting devices 120 may be electrically connected to the circuit pattern through a conductive bonding material. For example, the circuit board 110 may be selected from various kinds of printed circuit boards 110. However, the circuit board 110 is not limited to the printed circuit board 110 and may be any substrate having a wire capable of supplying electricity to the light emitting device 120.

The plurality of light emitting devices 120 may be electrically connected to each other by the circuit pattern to allow serial, parallel, or individual operation thereof. According to this embodiment, the circuit pattern may be formed to allow the plurality of light emitting devices 120 to operate independently.

Referring to FIG. 3, the first molding portion 130 may be formed on the circuit board 110.

The first molding portion 130 may be formed on the circuit board 110 to fill a space between the light emitting devices 120. The first molding portion 130 may be formed to fill the space between the light emitting devices 120 with a molding material discharged therefrom onto the circuit board 110. Here, each region of the first molding portion 130 in which the light emitting device 120 is disposed may correspond to the first opening 131. Alternatively, the first molding portion 130 may be previously formed with the plurality of first openings 131. The first molding portion 130 may be disposed on the circuit board 110 such that the light emitting devices 120 are placed in the first openings 131, respectively.

The first molding portion 130 may be formed to surround side surfaces of the light emitting devices 120 while exposing upper surfaces of the light emitting devices 120. In addition, the first molding portion 130 may be formed to have an upper surface flush with the upper surfaces of the light emitting devices 120.

The first molding portion 130 may be formed of a light transmissive material. For example, the first molding portion 130 may be formed of a transparent silicone resin or an epoxy resin. In addition, the first molding portion 130 may further contain fluorine (F). That is, the first molding portion 130 may be formed of a fluorine-containing silicone resin. When continuously exposed to UV light emitted from the light emitting device 120, the first molding portion 130 formed of the silicone resin can be cured by the UV light to be cracked or broken. To prevent this problem, the first molding portion 130 may be formed of the fluorine-containing silicone resin.

According to this embodiment, the plurality of light emitting devices 120 mounted on the circuit board 110 emit light in the same wavelength band. Accordingly, performance of the light emitting module 1001, such as color reproducibility, is not deteriorated even when light components emitted from the light emitting devices 120 adjacent to each other are mixed in the first molding portion 130 formed of the light transmissive material.

Alternatively, the first molding portion 130 may be formed of a light reflective material or a light blocking material. For example, the first molding portion 130 may be black silicone.

The first molding portion 130 formed of the light reflective material or the light blocking material can prevent light interference between the light emitting devices 120 adjacent to each other. The first molding portion 130 may emit the same quantity of light or a predetermined quantity of light for each region in which the light emitting device 120 is disposed. Accordingly, the first molding portion 130 formed of the light reflective material can improve light uniformity of the light emitting module 1001, or can allow easy control of the quantity of light emitted from the light emitting module 1001 for each pixel, region, or color of light.

Referring to FIG. 4, the wavelength conversion portions 140 may be formed.

The wavelength conversion portion 140 may be formed on the light emitting device 120. According to this embodiment, the wavelength conversion portion 140 may be formed to cover the upper surface of the light emitting device 120. In addition, the wavelength conversion portion 140 may expose an upper surface of the first molding portion 130. That is, the plurality of wavelength conversion portions 140 formed on the upper surfaces of the plurality of light emitting devices 120 may be separated from each other. The wavelength conversion portions 140 may be excited by light emitted from the light emitting devices 120 to emit light in different wavelength bands than light emitted from the light emitting devices 120.

The wavelength conversion portion 140 may include a light transmitting portion and a wavelength conversion material dispersed in the light transmitting portion.

The light transmitting portion may be a light transmitting resin, such as a silicone resin or an epoxy resin. Alternatively, the light transmitting portion may be a glass substrate or a glass sheet. However, the light transmitting portion is not limited thereto. The light transmitting portion may have a wavelength conversion material dispersed therein and may be any material capable of transmitting light emitted from the light emitting device 120 or light emitted from the wavelength conversion material.

The wavelength conversion material may include a phosphor and/or quantum dots. The wavelength conversion material may convert the wavelength of light emitted from the light emitting device 120. That is, the wavelength conversion material may excite the light emitted from the light emitting device 120 to emit light having a different wavelength from the light emitted from the light emitting device 120.

The quantum dots have UV curable properties. Accordingly, when the wavelength conversion material is composed of the quantum dots, a process of curing the wavelength conversion portion 140 after formation of the wavelength conversion portion 140 on the light emitting device 120 may be omitted. The wavelength conversion portion 140 including the quantum dots may be cured when the light emitting module 1001 emits light. For example, the wavelength conversion portion 140 including the quantum dots may be cured by light emitted from the light emitting device 120 during a test operation for determination of defects of the light emitting module 1001.

According to this embodiment, at least one of the plurality of wavelength conversion portions 140 may emit light in a different wavelength band than light emitted from other wavelength conversion portions 140. For example, the wavelength conversion portion 140 may include a first wavelength conversion portion 141 emitting red light, a second wavelength conversion portion 142 emitting green light, and a third wavelength conversion portion 143 emitting blue light.

The first wavelength conversion portion 141 may include a wavelength conversion material that converts light from the light emitting device 120 into red light, the second wavelength conversion portion 142 may include a wavelength conversion material that converts light from the light emitting device 120 into green light, and the third wavelength conversion portion 143 may include a wavelength conversion material that converts light from the light emitting device 120 into blue light.

In this embodiment, the wavelength conversion portion 140 includes three types of wavelength conversion portions 140. However, it should be understood that other implementations are possible. Alternatively, the plurality of wavelength conversion portions 140 may emit light having the same color. Alternatively, the plurality of wavelength conversion portions 140 may emit light having two kinds of colors or at least four kinds of colors.

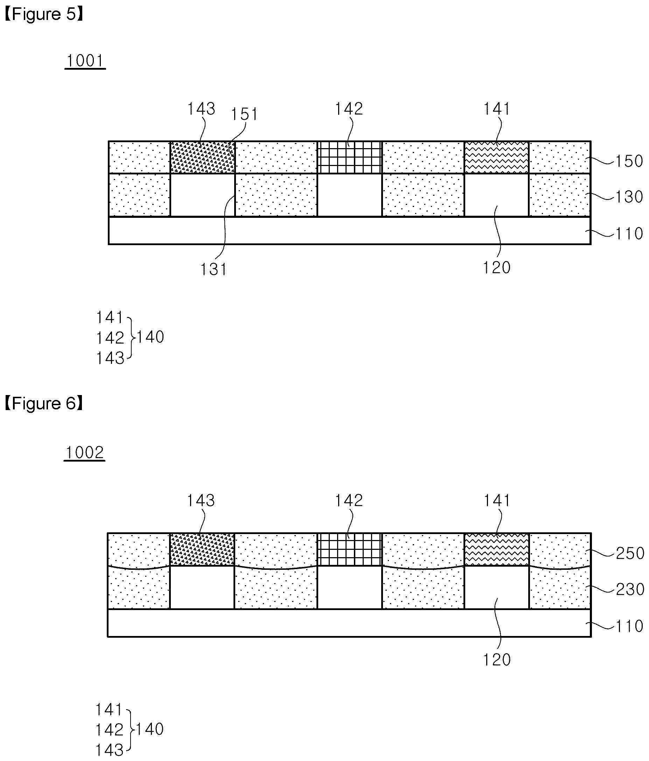

Referring to FIG. 5, the second molding portion 150 may be formed.

According to this embodiment, the second molding portion 150 may be formed on the first molding portion 130 to surround side surfaces of the wavelength conversion portions 140. That is, the second molding portion 150 may be formed to fill a space between the plurality of wavelength conversion portions 140. As shown in FIG. 5, the second molding portion 150 may expose an upper surface of the wavelength conversion portion 140. In addition, an upper surface of the second molding portion 150 may be flush with the upper surface of the wavelength conversion portion 140.

Like the first molding portion 130, the second molding portion 150 may be formed of a light transmissive material or a light reflective material. According to this embodiment, the second molding portion 150 may be formed of the same material as the first molding portion 130. However, it should be understood that other implementations are possible. Alternatively, the first molding portion 130 may be formed of a light transmissive material and the second molding portion 150 may be formed of a light reflective material, or vice versa.

The second molding portion 150 may be formed by discharging a molding material over the first molding portion 130 after formation of the wavelength conversion portions 140. In this case, each region of the second molding portion 150 where the wavelength conversion portion 140 is disposed may correspond to the second opening 151. Alternatively, the second molding portion 150 may be previously formed with the plurality of the second openings 151. Accordingly, the second molding portion 150 may be disposed on the first molding portion 130 such that the wavelength conversion portions 140 are inserted into the second openings 151, respectively.

Although omitted in this embodiment, a bonding portion may be further formed between the light emitting device 120 and the wavelength conversion portion 140 to improve bonding strength between the light emitting device 120 and the wavelength conversion portion 140. The bonding portion may be formed of a light transmissive material exhibiting bonding strength.

A typical micro-LED includes a growth substrate 90 and has a structure in which the wavelength conversion portions 140 are formed on the growth substrate 90. That is, since the growth substrate 90 is not removed from the typical micro-LED, the growth substrate 90 contacts the wavelength conversion portions 140. However, since the growth substrate 90 is omitted from the light emitting device 120, which corresponds to a micro-LED according to an embodiment of the present invention, the wavelength conversion portions 140 contact the semiconductor structure rather than the growth substrate 90. Alternatively, when the light emitting device further includes the bonding portion, the semiconductor structure may adjoin the bonding portion.

The following description will focus on differences between various embodiments and the above embodiments. Therefore, for detailed description of components and effects whose description is omitted or briefly described, refer to the description of the above embodiments.

FIG. 6 is a sectional view of a light emitting module according to a second embodiment of the present invention.

The light emitting module 1002 according to the second embodiment has the same structure as the light emitting module 1001 (see FIG. 1 to FIG. 5) of the first embodiment excluding a first molding portion 230 and a second molding portion 250.

The first molding portion 230 may have a downwardly concave upper surface. Here, the upper surface of the first molding portion 230 may have a periphery flush with a periphery of an upper surface of the light emitting device 120. Alternatively, the first molding portion 230 may have a concave structure in which the height of the upper surface thereof gradually decreases towards the interior from the periphery of the upper surface thereof. That is, the first molding portion 230 may have a thickness gradually decreasing from a side surface thereof towards the interior. Here, the thickness of the first molding portion 230 is a length between the upper and lower surfaces thereof.

Since the second molding portion 250 covers the upper surface of the first molding portion 230, a lower surface of the second molding portion 250 may be downwardly convex toward the interior from a periphery thereof. Alternatively, the second molding portion 250 may have a flat upper surface. Therefore, the second molding portion 250 may have a structure in which the thickness increases from the side surface to the inside. Alternatively, the second molding portion 250 may have a flat upper surface. Accordingly, the second molding portion 250 may have a structure in which the thickness of the second molding portion 250 gradually increases from the side surface thereof towards the interior.

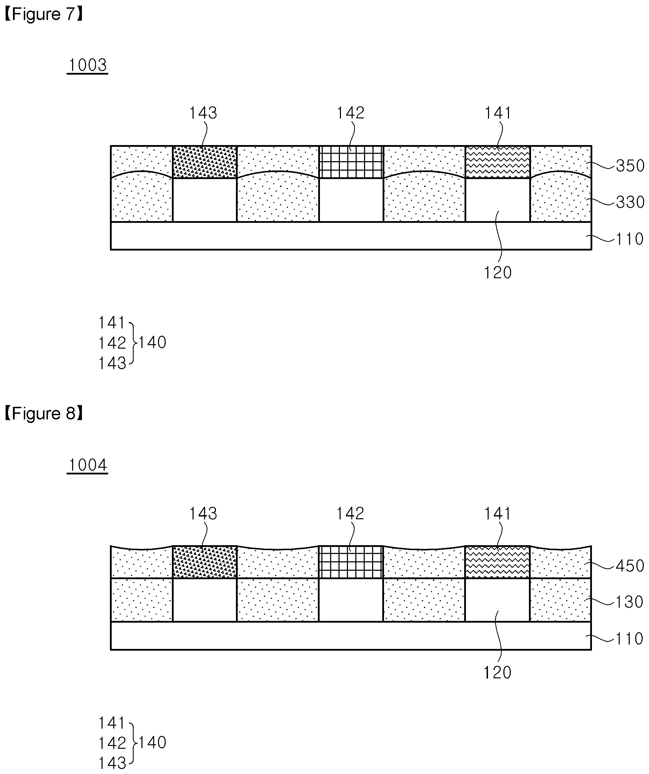

FIG. 7 is a sectional view of a light emitting module according to a third embodiment of the present invention.

The light emitting module 1003 according to the third embodiment has the same structure as the light emitting module 1003 according to the third embodiment excluding a first molding portion 330 and a second molding portion 350.

The first molding portion 330 may have an upwardly convex upper surface. Here, the upper surface of the first molding portion 330 may have a periphery flush with the periphery of the upper surface of the light emitting device 120. Alternatively, the first molding portion 330 may have a concave structure in which the height of the upper surface thereof gradually increases towards the interior from the periphery of the upper surface thereof. That is, the first molding portion 330 may have a thickness gradually increasing from a side surface thereof towards the interior.

Since the second molding portion 350 is formed to cover the upper surface of the first molding portion 330, a lower surface of the second molding portion 350 may have a structure downwardly concave toward the interior from a periphery thereof. Alternatively, the second molding portion 350 may have a flat upper surface. Accordingly, the second molding portion 350 may have a structure in which the thickness of the second molding portion 350 gradually decreases from a side surface thereof towards the interior.

FIG. 8 is a sectional view of a light emitting module according to a fourth embodiment of the present invention.

The light emitting module 1004 according to the fourth embodiment has the same structure as the light emitting module 1001 (see FIG. 1 to FIG. 5) according to the first embodiment excluding a second molding portion 450.

The second molding portion 450 may have a downwardly concave upper surface. Here, the upper surface of the second molding portion 450 may have a periphery flush with the periphery of the upper surface of the wavelength conversion portion 140. Alternatively, the second molding portion 450 may have a concave structure in which the height of the upper surface thereof gradually decreases towards the interior from the periphery of the upper surface thereof. That is, the second molding portion 450 may have a thickness gradually decreasing from the side surface thereof towards the interior.

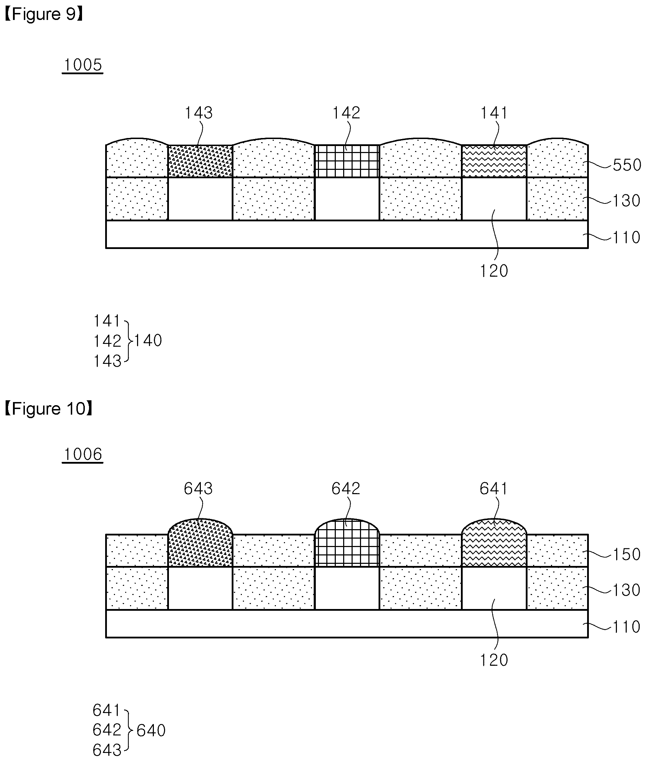

FIG. 9 is a sectional view of a light emitting module according to a fifth embodiment of the present invention.

The light emitting module 1005 according to the fifth embodiment has the same structure as the light emitting module 1001 (see FIG. 1 to FIG. 5) according to the first embodiment excluding a second molding portion 550.

The second molding portion 550 may have an upwardly convex upper surface. Here, the upper surface of the second molding portion 550 may have a periphery flush with the periphery of the upper surface of the wavelength conversion portion 140. Alternatively, the second molding portion 550 may have a convex structure in which the height of the upper surface thereof gradually increases towards the interior from the periphery of the upper surface thereof. That is, the second molding portion 550 may have a thickness gradually increasing from the side surface thereof towards the interior

Referring to FIG. 8 and FIG. 9, each of the light emitting module 1005 according to the fourth embodiment and the light emitting module 1005 according to the fifth embodiment includes the first molding portion 130 that has a flat upper surface. However, it should be understood that other implementations are possible. In each of the light emitting module 1005 according to the fourth embodiment and the light emitting module 1005 according to the fifth embodiment, the upper surface of the first molding portion 130 may have a convex or concave structure.

Furthermore, in the light emitting modules 1005 according to the fourth and fifth embodiments, the periphery of the upper surface of the second molding portion 550 may be flush with the periphery of the upper surface of the wavelength conversion portion 140, without being limited thereto. Alternatively, in the light emitting modules 1005 according to the fourth and fifth embodiments, the periphery of the upper surface of the second molding portion 550 may be placed beneath the periphery of the upper surface of the wavelength conversion portion 140. That is, the periphery of the upper surface of the second molding portion 550 may adjoin the side surface of the wavelength conversion portion 140.

FIG. 10 is a sectional view of a light emitting module according to a sixth embodiment of the present invention.

The light emitting module 1006 according to the sixth embodiment has the same structure as the light emitting module 1001 (see FIG. 1 to FIG. 5) according to the first embodiment excluding a wavelength conversion portion 640.

In this embodiment, the wavelength conversion portion 640 may have an upwardly convex upper surface. That is, the wavelength conversion portion 640 may have a thickness gradually increasing from the side surface thereof towards the interior. The upper surface of the wavelength conversion portion 640 corresponds to a light exit surface of the wavelength conversion portion 640 through which light having passed through the wavelength conversion portion 640 is emitted.

Although FIG. 10 shows the wavelength conversion portion 640 having the convex upper surface, the upper surface of the wavelength conversion portion 640 may have a concave structure. A beam angle of light emitted from the wavelength conversion portion 640 may be adjusted by the convex or concave structure of the wavelength conversion portion 640. Furthermore, a beam angle of the light emitting module 1006 may be adjusted by the convex or concave structure of the wavelength conversion portion 640.

Although the upper surfaces of the first molding portion 130 and the second molding portion 150 have a flat structure, it should be understood that other implementations are possible. The first molding portion 130 and the second molding portion 150 may have various structures as described in the above embodiments.

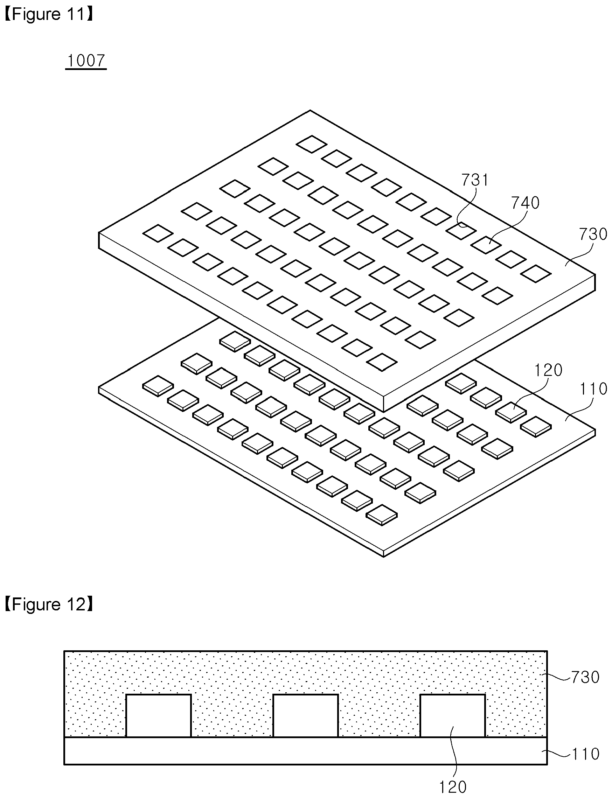

FIG. 11 to FIG. 14 are views of a light emitting module according to a seventh embodiment of the present invention.

FIG. 11 is a perspective view of the light emitting module according to the seventh embodiment of the present invention.

Referring to FIG. 11, the light emitting module according to the seventh embodiment may include a circuit board 110, a plurality of light emitting devices 120, a molding portion 730, and a plurality of wavelength conversion portions 740.

The plurality of light emitting devices 120 may be disposed on the circuit board 110 to be individually operated. In addition, the light emitting device 120 according to this embodiment may be a light emitting diode having an n-type semiconductor layer disposed to face a light emission surface thereof. For example, the light emitting device 120 may emit UV light.

The molding portion 730 may be disposed on an upper surface of the substrate, on which the light emitting devices 120 are disposed. The molding portion 730 may be formed with a plurality of openings 731. The light emitting devices 120 and the wavelength conversion portions 740 may be disposed in the openings 731 of the molding portion 730, respectively. Although not shown in FIG. 11, when the molding portion 730 is formed on the circuit board 110, the light emitting device 120 may be disposed at a lower portion of the opening 731 of the molding portion 730 and the wavelength conversion portion 740 may be disposed at an upper portion of the opening 731 corresponding to the top of the light emitting device 120.

The molding portion 730 according to this embodiment may be formed of the same material as the first molding portion 130 or the second molding portion 150 of the light emitting module 1001 (see FIG. 1 to FIG. 5) according to the first embodiment.

FIG. 12 to FIG. 14 are views illustrating a method of manufacturing the light emitting module according to the seventh embodiment of the present invention.

For description of a method in which the plurality of light emitting devices 120 is mounted on the circuit board 110 and the growth substrate 90 is removed from the plurality of light emitting devices 120, refer to the method of manufacturing the light emitting module 1001 (see FIG. 1 to FIG. 5) according to the first embodiment.

Referring to FIG. 12, the molding portion 730 may be formed.

The molding portion 730 may be formed on the circuit board 110 on which the light emitting devices 120 are mounted. In addition, the molding portion 730 may be formed to fill a space between the light emitting devices 120 while covering the top of each of the light emitting devices 120.

The molding portion 730 of the light emitting module 1007 according to this embodiment may be formed of the same material as the first molding portion or the second molding portion described above. That is, the molding portion 730 may be formed of a light transmissive material or a light reflective material.

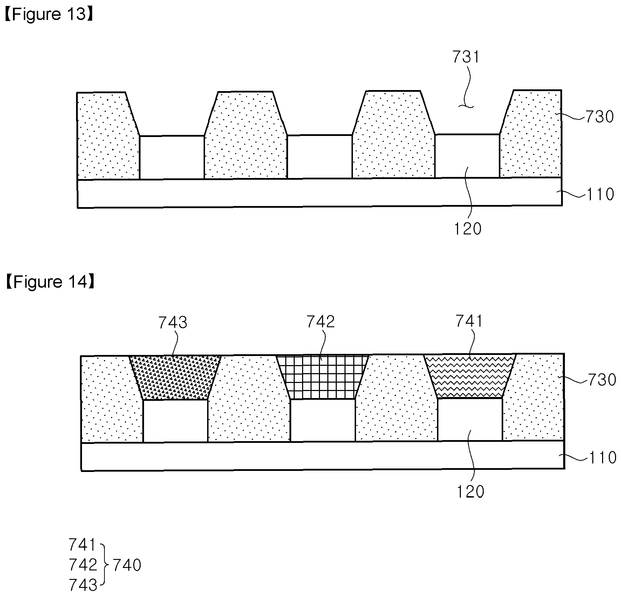

Referring to FIG. 13, the molding portion 730 may be formed with the openings 731.

Each of the openings 731 of the molding portion 730 may be formed on the light emitting device 120. In addition, the openings 731 of the molding portion 730 may be formed to expose upper surfaces of the light emitting devices 120.

In this embodiment, the openings 731 are formed after formation of the molding portion 730 on the circuit board 110. However, the method of forming the molding portion 730 having the openings 731 is not limited thereto. For example, the molding portion 730 previously formed with a plurality of openings 731 may be disposed on the circuit board 110. Here, the molding portion 730 may be disposed on the circuit board 110 such that the light emitting devices 120 are inserted into the plurality of openings 731, respectively.

In this embodiment, the molding portion 730 may be formed in consideration of the thicknesses of the light emitting devices 120 and the wavelength conversion portions 740 disposed in the openings 731.

Referring to FIG. 14, the wavelength conversion portion 740 may be formed.

According to this embodiment, the wavelength conversion portion 740 may be formed to fill the openings 731 of the molding portion 730. Accordingly, the wavelength conversion portion 740 may be formed to cover the upper surfaces of the light emitting devices 120.

In addition, a lower surface of the wavelength conversion portion 740 contacts the upper surfaces of the light emitting device 120 and an upper surface of the wavelength conversion portion 740 may be flush with an upper surface of the molding portion 730. Accordingly, the sum of the thicknesses of the light emitting device 120 and the wavelength conversion portion 740 may be equal to the thickness of the molding portion 730.

The wavelength conversion portion 740 may include a first wavelength conversion portion 741 that emits red light, a second wavelength conversion portion 742 that emits green light, and a third wavelength conversion portion 743 that emits blue light.

Although FIG. 14 shows the wavelength conversion portion 740 having a flat upper surface, it should be understood that other implementations are possible. Alternatively, the upper surface of the wavelength conversion portion 740 may have a convex or concave structure.

Although omitted in this embodiment, a light transmissive bonding portion may be further disposed between the light emitting device 120 and the wavelength conversion portion 740.

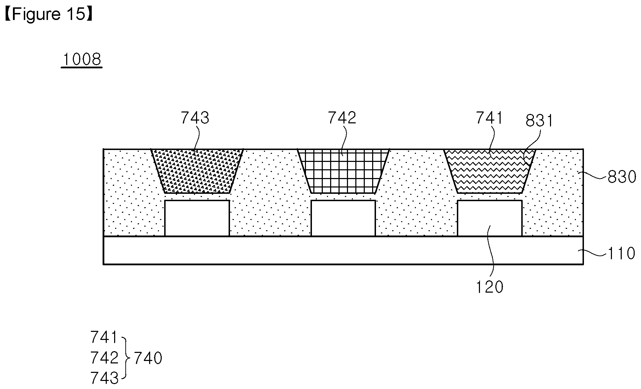

FIG. 15 is a sectional view of a light emitting module according to an eighth embodiment of the present invention.

In the light emitting module 1008 according to the eighth embodiment, wavelength conversion portions 740 may be formed above the light emitting devices 120 to be spaced apart therefrom, respectively. A molding portion 830 may be disposed between the light emitting devices 120 and the wavelength conversion portions 740. In addition, the molding portion 830 may be formed to cover side surfaces of the light emitting devices 120 and the wavelength conversion portions 740.

According to this embodiment, the molding portion 830 is formed with openings 831 on the upper surfaces of the light emitting devices 120 so as not to expose the upper surfaces of the light emitting devices 120. That is, the bottom of each of the openings 831 is spaced apart from the upper surface of the light emitting device 120 such that the molding portion 830 is disposed between the opening 831 and the upper surface of the light emitting device 120.

The wavelength conversion portions 740 may be formed in the openings 831 of the molding portion 830.

According to this embodiment, since the molding portion 830 is formed to cover both the side surface and the upper surface of the light emitting device 120, the molding portion 830 may be formed of a light transmissive material to allow light emitted from the light emitting device 120 to enter the wavelength conversion portion 740 therethrough.

In the light emitting module 1008 according to this embodiment, since the molding portion 830 is placed between the light emitting devices 120 and the wavelength conversion portions 740, the light emitting devices 120 do not directly contact the wavelength conversion portion 740. Accordingly, the light emitting module can prevent heat generated from the light emitting devices 120 from being directly transferred to the wavelength conversion material of the wavelength conversion portions 740. Accordingly, the light emitting module 1008 according to this embodiment can prevent or suppress discoloration of light or deterioration in luminous efficacy due to degradation of the wavelength conversion portions 740 caused by heat from the light emitting devices 120.

Further, in the light emitting module 1008 according to this embodiment, the thickness of the wavelength conversion portions 740 may be adjusted through adjustment in depth of the openings 831. Further, as the thickness of the wavelength conversion portions 740 is adjusted, the amount of the wavelength conversion material disposed on the light emitting devices 120 may also be adjusted. Accordingly, the light emitting module 1008 according to this embodiment may adjust chromaticity and quantity of light by the wavelength conversion portions 740 through adjustment in thickness of the wavelength conversion portions 740.

Referring to FIG. 15, the plurality of openings 831 formed in the molding portion 830 has the same depth. However, it should be understood that other implementations are possible. Alternatively, at least one of the openings 831 may have a different thickness than other openings 831. Accordingly, among a plurality of wavelength conversion portions 740, at least one wavelength conversion portion 740 may have a different thickness than other wavelength conversion portions 740. For example, the plurality of wavelength conversion portions 740 may be formed to have different thicknesses depending upon the kind of wavelength conversion material.

Various embodiments of the light emitting module including the light emitting devices having an n-type semiconductor layer disposed to face a light emission surface have been described with reference to FIG. 1 to FIG. 15. Next, various embodiments of a light emitting module including vertical type light emitting devices will be described.

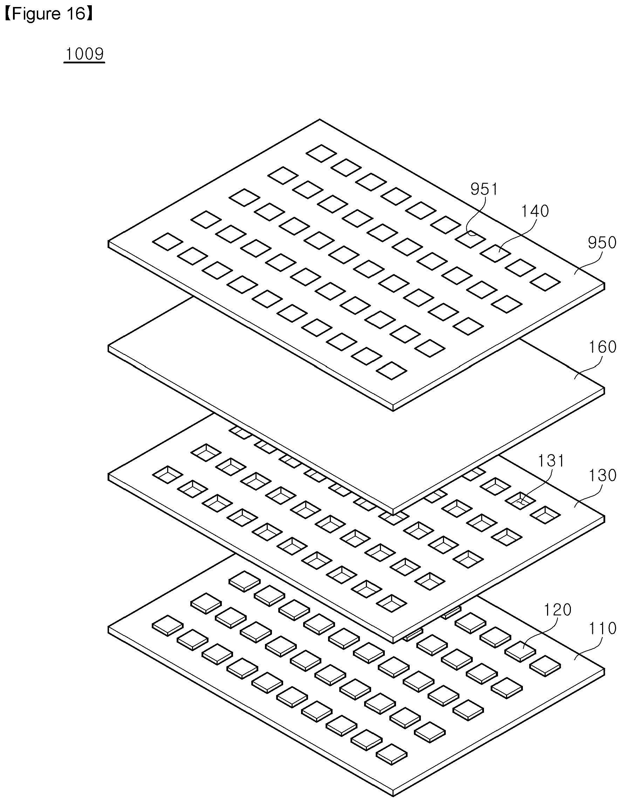

FIG. 16 to FIG. 24 are views of a light emitting module according to a ninth embodiment of the present invention.

FIG. 16 is a sectional view of a light emitting module according to a ninth embodiment of the present invention.

Referring to FIG. 16, the light emitting module 1009 according to the ninth embodiment may include a circuit board 110, a plurality of light emitting devices 120, a first molding portion 130, an electrode 160, a second molding portion 950, and wavelength conversion portions 140.

The plurality of light emitting devices 120 may be disposed on the circuit board 110 and may be electrically connected to the circuit board 110 and the electrode 160.

The light emitting device 120 according to this embodiment may be a vertical type light emitting diode. Accordingly, two electrodes of the light emitting device 120 may be placed in different directions. For example, one electrode of the light emitting device 120 may be formed on a lower surface of the light emitting device 120 to be electrically connected to the circuit board 110 and the other electrode may be formed on an upper surface of the light emitting device 120 to be connected to the light emitting device 120 and an external power source. For example, the electrode may be the electrode 160.

The first molding portion 130 may be disposed on the substrate on which the light emitting devices 120 are mounted. The first molding portion 130 may include a plurality of first openings. The first openings may be formed in the form of through-holes formed from an upper surface of the first molding portion 130 to a lower surface thereof. The plurality of first openings may be provided with the light emitting devices 120, respectively. Accordingly, upper surfaces of the plurality of light emitting devices 120 may be exposed through the first openings of the molding portion, respectively.

The electrode 160 may be disposed on the first molding portion 130. The electrode 160 may be placed in a light emission direction of the plurality of light emitting devices 120. In this embodiment, the electrode 160 may be formed on the plurality of light emitting devices 120.

The electrode 160 according to this embodiment is a conductive material and may be formed of a material that transmits light or minimizes interference in light propagation. For example, the electrode 160 may be formed of at least one selected from among indium tin oxide (ITO), graphene, PEDOT:PSS, silver nanowires, and carbon nanotubes (CNT). However, according to this embodiment, the electrode 160 is not limited thereto and may be formed of any typical materials known as the electrode 160.

In general, a conductive material, such as a metal, used as a wire does not transmit light. Accordingly, since the conductive material including a metal placed in a light emission direction of the light emitting devices absorbs or reflects light, luminous efficacy of modules and devices adopting the light emitting devices can be reduced. However, since the electrode 160 transmits light, the electrode 160 can prevent deterioration in luminous efficacy through minimization of light loss.

Referring to FIG. 16, the electrode 160 may be prepared in the form of a sheet that covers the entire upper surface of the first molding portion 130. Here, the electrode 160 may be electrically connected to the electrodes formed on the upper surfaces of the plurality of light emitting devices 120 exposed through the first openings of the first molding portion 130. That is, the electrode 160 is a common electrode and may be electrically connected to the plurality of light emitting devices 120. The electrode 160 may be formed over the upper surfaces of the light emitting devices 120 and the upper surface of the first molding portion 130. Alternatively, an interface between side surfaces of the light emitting devices 120 and the first molding portion 130 may overlap the electrode 160.

Although not shown in this embodiment, the electrode 160 may be electrically connected to a circuit pattern formed on the circuit board 110 by covering a side surface of the first molding portion 130 or penetrating the first molding portion 130. Alternatively, the electrode 160 may be electrically connected to the circuit board 110 through a separate conductive material formed to pass through the first molding portion 130. Here, the plurality of light emitting devices 120 may share the electrode 160 and may be individually operated by the circuit pattern on the circuit board 110 and the electrode 160.

The second molding portion 950 and the wavelength conversion portions 140 may be formed on the electrode 160. The second molding portion 950 may be formed with a plurality of second openings 951. The second openings 951 may be placed above the first openings 131 of the first molding portion.

The wavelength conversion portions 140 may be disposed in the plurality of second openings 951 of the second molding portion 950, respectively. Accordingly, the wavelength conversion portion 140 may be placed above each of the light emitting devices 120. Light emitted through the upper surfaces of the light emitting devices 120 may pass through the electrode 160 and the wavelength conversion portions 140 to be emitted from the light emitting module 1009.

According to this embodiment, the first molding portion 130 and the second molding portion 950 may have the same features as the first molding portion 130 and the second molding portion 150 of the light emitting module 1001 (see FIG. 1 to FIG. 5) according to the first embodiment. In addition, although not shown in the drawings, an upper surface of the first molding portion 130 disposed between the light emitting devices 120 may have a concave or convex surface and the electrode 160 may have a concave or convex surface corresponding to the shape of the first molding portion 130.

Alternatively, some region of the electrode 160 disposed on the upper surfaces of the light emitting devices 120 may have a flatter shape than some region of the electrode 160 disposed between the light emitting devices 120. As a result, stable electrical contact can be made between the electrode and the light emitting devices.

Alternatively, the upper surface of each of the light emitting devices 120 may have a light exit surface having irregularity and the electrode 160 may have a shape corresponding to the light exit surface of the light emitting device 120. Accordingly, some region of the electrode 160 disposed between the light emitting devices 120 may have a flatter shape than some region of the electrode 160 disposed on the upper surface of the light emitting device 120. As a result, an interface at which materials having different indices of refraction are disposed on the light exit surface has irregularity to improve light extraction efficiency and a contact area between the electrode 160 and the light emitting devices 120 is increased to improve current injection efficiency.

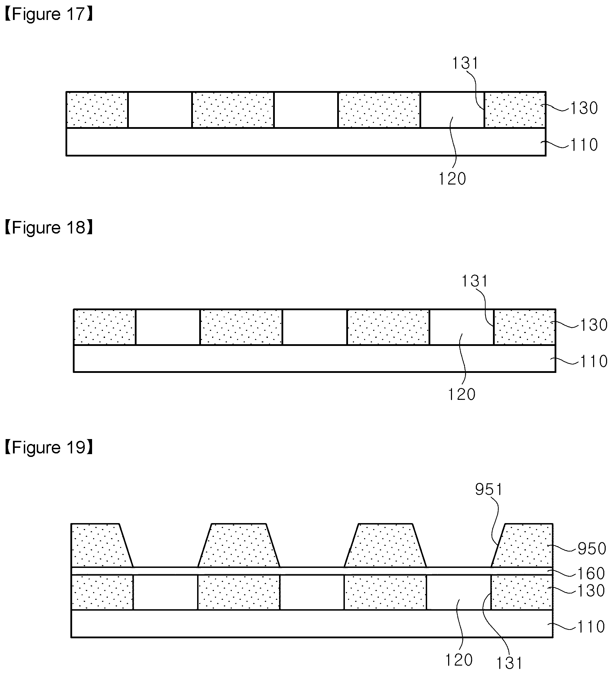

FIG. 17 to FIG. 24 are views illustrating a method of manufacturing the light emitting module 1001 according to the ninth embodiment of the present invention.

For description of a method in which the plurality of light emitting devices 120 is mounted on the circuit board 110 and the growth substrate 90 is removed from the plurality of light emitting devices 120, refer to the method of manufacturing the light emitting module 1009 (see FIG. 1 to FIG. 5) according to the first embodiment.

When the light emitting devices 120 are mounted on the circuit board 110, one electrode formed on a lower surface of the light emitting device 120 may be electrically connected to the circuit pattern on the circuit board 110.

Referring to FIG. 17, the first molding portion 130 may be formed.

The first molding portion 130 may be formed on the circuit board 110 to fill a space between the light emitting devices 120. Here, the first molding portion 130 may be formed to cover the side surfaces of the light emitting devices 120 while exposing the upper surfaces of the light emitting device 120.

Although FIG. 17 shows the molding portion having a flat upper surface, the molding portion may have a convex or concave upper surface as in the above embodiments.

Referring to FIG. 18, the electrode 160 may be formed on the first molding portion 130 and the light emitting devices 120.

The electrode 160 may be formed to cover the upper surface of the first molding portion 130 and the upper surfaces of the light emitting devices 120. In this embodiment, the electrode 160 has flat upper and lower surfaces. However, the structure of a region of the electrode 160 covering the upper surface of the first molding portion 130 may vary depending on the structure of the first molding portion 130. For example, when the first molding portion 130 has a convex upper surface, the region of the electrode 160 covering the first molding portion 130 may have a convex structure corresponding to the upper surface of the first molding portion 130. Alternatively, when the first molding portion 130 has a concave upper surface, the region of the electrode 160 covering the first molding portion 130 may have a concave structure corresponding to the upper surface of the first molding portion 130.

Although not shown in the drawings, a portion of the electrode 160 may be electrically connected to the circuit pattern of the circuit board 110 through the first molding portion 130. Alternatively, the first molding portion 130 may be formed with a through-hole filled with a conductive material such that the circuit board 110 is electrically connected to the electrode 160 therethrough.

Referring to FIG. 19, the second molding portion 950 may be formed on the electrode 160.

The second molding portion 950 may include a plurality of second openings 951. Here, each of the second openings 951 may have a hole structure penetrating the second molding portion 950. Accordingly, the electrode may be exposed through the second openings 951 of the second molding portion 950.

According to this embodiment, after the second molding portion 950 is formed to cover the entire upper surface of the electrode 160, the second openings 951 may be formed above the light emitting devices 120, respectively. Alternatively, the second molding portion 950 previously formed with a plurality of second openings 951 may be disposed on the electrode 160.

In this embodiment, the second openings 951 of the second molding portion 950 have a structure in which the diameter of each of the second openings 951 gradually increases from a lower portion to an upper portion. Alternatively, each of the second openings 951 of the second molding portion 950 may have a constant diameter.

Although FIG. 19 shows the second molding portion 950 having a flat upper surface, it should be understood that other implementations are possible. The second molding portion 950 may have a convex or concave structure as in the above embodiments.

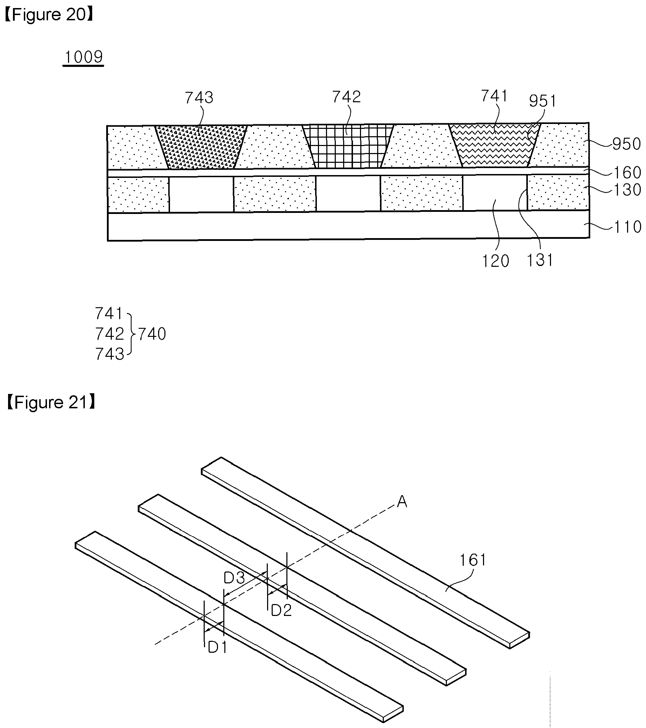

Referring to FIG. 20, the wavelength conversion portions 140 are formed.

The wavelength conversion portions 140 may be formed to fill the second openings 951 of the second molding portion 950.

The wavelength conversion portions 140 may include a first wavelength conversion portion 741 that emits red light, a second wavelength conversion portion 742 that emits green light, and a third wavelength conversion portion 743 that emits blue light.

Although FIG. 20 shows the wavelength conversion portions 140 having a flat upper surface, it should be understood that other implementations are possible. The wavelength conversion portions 140 may have a convex or concave upper surface.

In this embodiment, the wavelength conversion portions 140 are formed after formation of the second molding portion 950. Alternatively, the second molding portion 950 may be formed after formation of the wavelength conversion portions 140. For example, after formation of the electrode 160, the wavelength conversion portions 140 may be formed to be disposed on the plurality of light emitting devices 120, respectively. Then, the second molding portion 950 may be formed on the electrode 160 to fill a space between the wavelength conversion portions 140. In this case, regions of the second molding portion 950, in which the wavelength conversion portions 140 are disposed, may become the second openings 951.

The light emitting module 1009 according to the ninth embodiment includes the electrode 160 in the form of a sheet covering both the first molding portion 130 and the light emitting devices 120. However, it should be understood that the electrode 160 is not limited thereto.

FIG. 21 is a view of another embodiment of the electrode of the light emitting module according to the present invention.

Referring to FIG. 21, the light emitting module may include a plurality of elongated electrodes 161.

The elongated electrodes 161 may be electrically connected to the plurality of light emitting devices 120 placed in the same column or in the same row.

That is, the electrodes 161 according to this embodiment may electrically connect the plurality of light emitting devices 120 to each other in each column or row.

In application of the electrodes 161 according to this embodiment, a space between the electrodes 161 may be filled with the first molding portion or the second molding portion described in the above embodiments. Accordingly, the first molding portion or the second molding portion may have different thicknesses in a region where the electrodes 161 are formed and in a region where the electrode 161 is not formed.

In a cross-sectional view of the electrode 161 taken in a perpendicular direction (A) with respect to the length of the electrode 161, a deviation of cross-sectional widths D1, D2 of the electrodes 161 disposed in different rows or columns with a separation distance D3 therebetween may be within 10%. Alternatively, the separation distance D3 between the electrodes 161 may be greater than the cross-sectional widths D1, D2 of the electrodes 161 adjacent to each other. Alternatively, the separation distance D3 between the electrodes 161 may be greater than a cross-sectional width of the light emitting devices 120. Alternatively, the cross-sectional width D1 or D2 of the electrodes 161 may be smaller than the cross-sectional width of the light emitting devices 120.

The light emitting devices 120 may have a thickness of 10 µm or less and first electrodes 163 or second electrodes 164 may have a smaller thickness than the light emitting devices 120. Accordingly, a path for light to reach the wavelength conversion portion 740 is shortened, thereby increasing luminous efficacy.

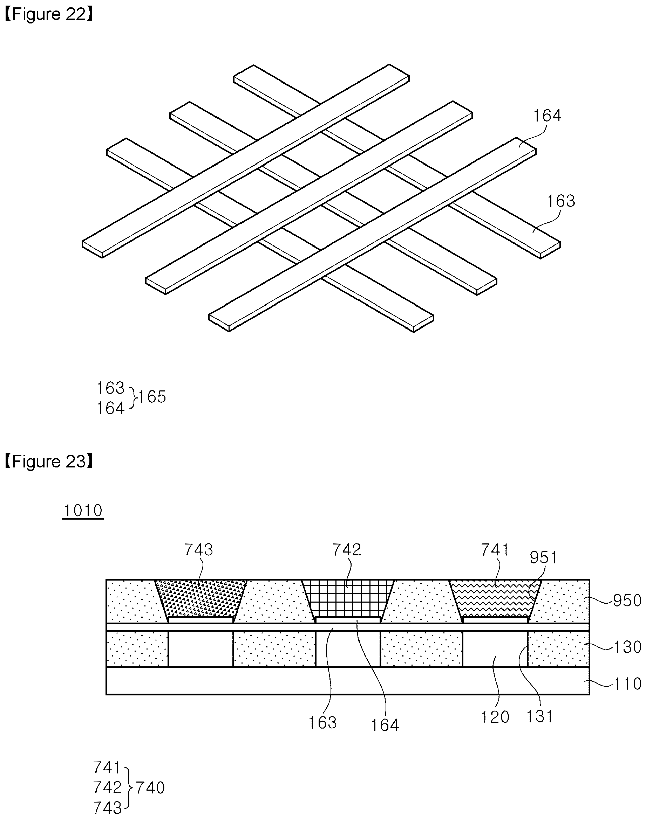

FIG. 22 and FIG. 23 are views of other examples of the electrode of the light emitting module according to the embodiment of the present invention.

FIG. 22 is a view of another example of the electrode of the light emitting module according to the embodiment of the present invention. In addition, FIG. 23 is a sectional view of a light emitting module according to a tenth embodiment of the present invention.

The light emitting module 1010 according to the tenth embodiment is a light emitting module to which an electrode 165 shown in FIG. 22 is applied.

Referring to FIG. 22, the light emitting module may include a plurality of elongated electrodes 165. In addition, the elongated electrodes 165 may be formed to connect all of the light emitting devices 120 arranged in columns and the light emitting devices 120 arranged in rows to each other. That is, the electrodes 165 may include a plurality of first electrodes 163 and a plurality of second electrodes 164. The ohmic electrodes 165 may have a lattice form by the first electrodes 163 and the second electrodes 164. In addition, in a cross-sectional view of the electrode 163 or 164 taken in a perpendicular direction (A) with respect to the length of the electrode 163 or 164, a deviation of cross-sectional widths D1 and D2 of the electrodes 163 or 164 disposed in different rows or columns with a separation distance D3 therebetween may be within 10%. Alternatively, the separation distance D3 between the electrodes 163 or 164 may be greater than the cross-sectional widths D1 and D2 of the electrodes 163 or 164 adjacent to each other. Alternatively, the separation distance D3 between the electrodes 163 or 164 may be greater than a cross-sectional width of the light emitting devices 120. Alternatively, the cross-sectional width D1 or D2 of the electrodes 163 or 164 may be smaller than the cross-sectional width of the light emitting devices 120.

Here, the light emitting devices 120 may be disposed under intersection regions between the first electrodes 163 and the second electrodes 164. Accordingly, referring to FIG. 23, the electrodes 165 may be formed in two layers on the upper surface of the light emitting devices 120. Alternatively, the electrodes 165 may be formed in a single layer in some region of the upper surface of the first molding portion 130 and may not be present in the other region of the upper surface of the first molding portion 130.

In addition, among the electrodes 165 formed in two layers on the light emitting devices 120, the second electrodes 164 may be placed in the openings of the second molding portion 950. Here, the wavelength conversion portions 740 may be placed above the second electrodes 164. Accordingly, the second electrodes 164 and the wavelength conversion portions 740 may be placed in the second openings 951 of the second molding portion 950. In addition, a total thickness of the electrodes disposed on the light emitting device 120 may be greater than the thickness of the electrode disposed on the first molding portion 130 between the light emitting devices 120.

In another embodiment, although not shown in the drawings, an insulation layer may be further disposed between the first electrodes 163 and the second electrodes 164 to electrically insulate or separate the first electrodes 163 from the second electrodes 164. As a result, a plurality of columns and a plurality of rows may be electrically insulated from each other, and the light emitting devices 120 electrically connected to the first electrodes 163 become different from the light emitting devices 120 electrically connected to the second electrodes 164, thereby enabling implementation of complicated electrical connection and circuit configuration through the electrodes.

The light emitting devices 120 may have a thickness of 10 µm or less and the first electrodes 163 or the second electrodes 164 may have a smaller thickness than the light emitting devices 120. Accordingly, a path for light to reach the wavelength conversion portion 740 is shortened, thereby increasing luminous efficacy.

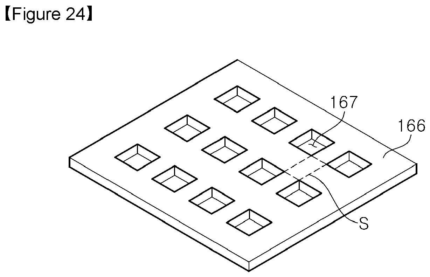

FIG. 24 is a view of yet another example of the electrode of the light emitting module according to the embodiment of the present invention.

According to this embodiment, an electrode 166 may have a mesh structure including a plurality of openings 167 each having a through-hole shape.

The openings 167 of the electrode 166 may be formed in a region in which a molding portion is formed. That is, the openings 167 of the electrode 166 may be filled with the molding portion. For the molding portion divided into a first molding portion and a second molding portion, the openings 167 of the electrode 166 may be filled with the first molding portion and/or the second molding portion.

The light emitting device 120 may be placed under a region between the openings 157 of the electrode 166. For example, the light emitting device 120 may contact a region S between four adjacent openings 167 of the electrode 166 to be electrically connected thereto.

The electrodes 166 described above in various examples may be applied to light emitting modules according to various embodiments described below.

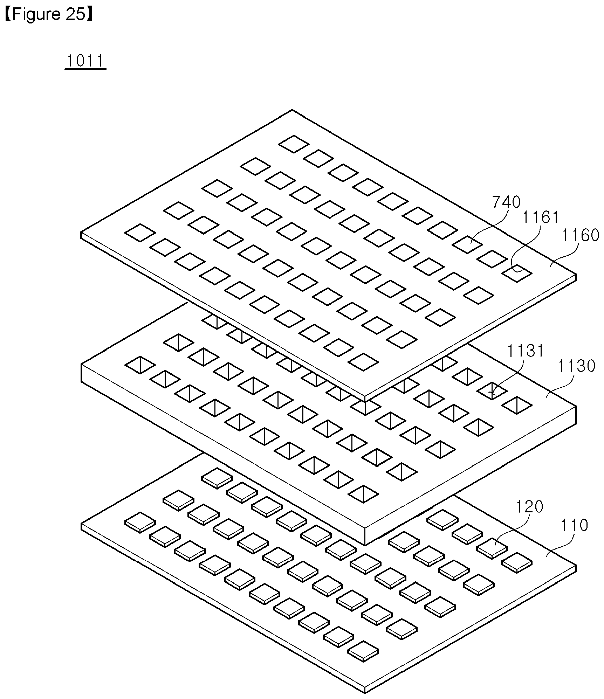

FIG. 25 is a perspective view of a light emitting module according to an eleventh embodiment of the present invention.

Referring to FIG. 25, the light emitting module 1011 according to the eleventh embodiment may include a circuit board 110, a plurality of light emitting devices 120, a molding portion 1130, an electrode 1160, and wavelength conversion portions 740.

According to this embodiment, the molding portion 1130 formed with openings 1131 may be disposed on the circuit board 110, on which the light emitting devices 120 are mounted. The openings 1131 of the molding portion 1130 are open at upper and lower portions thereof and have a through-hole structure passing through the molding portion 1130. The molding portion 1130 has a greater thickness than the light emitting devices 120. Accordingly, the openings 1131 of the molding portion 1130 may also have a greater depth than the thickness of the light emitting devices 120.

The electrode 1160 formed with recesses 1161 where the electrode 1161 has a lower height than other regions may be disposed on the molding portion 1130 and the light emitting devices 120. The recesses 1161 of the electrode 1160 may have a structure in which side and bottom surfaces thereof are surrounded by inner walls of the electrode 1160. Accordingly, the recesses 1161 of the electrode 1160 at least partially overlap with the light emitting surfaces of the light emitting devices 120. Although not shown in the drawings, the electrode 1160 has a structure in which a portion formed with the recess 1161 protrudes in a direction opposite to a light emission direction, that is, in a downward direction. In addition, the wavelength conversion portions 740 may be disposed in the recesses 1161 of the electrode 1160. That is, the wavelength conversion portions 740 may be disposed inside the portions of the electrode 1160 protruding downwards.

When the light emitting devices 120 and the molding portion 1130 are disposed on the upper surface of the circuit board 110, the molding portion 1130 is disposed between the light emitting devices 120. Accordingly, the light emitting devices 120 are inserted into the openings 1131 of the molding portion 1130. When the electrode 1160 is disposed on the upper surface of the molding portion 1130, concave portions of the electrode 1160 on which the wavelength conversion portions 740 are disposed may be inserted into or disposed in the openings 1131 of the molding portion 1130.

Accordingly, the light emitting module 1011 according to the eleventh embodiment may include a structure in which the light emitting devices 120, the electrode 1160 and the wavelength conversion portions 740 are disposed in the openings 1131 of the molding portion 1130. When the wavelength conversion portions 740 are disposed above the light emitting devices 120, the electrode 1160 may be disposed between the light emitting devices 120 and the wavelength conversion portions 740.

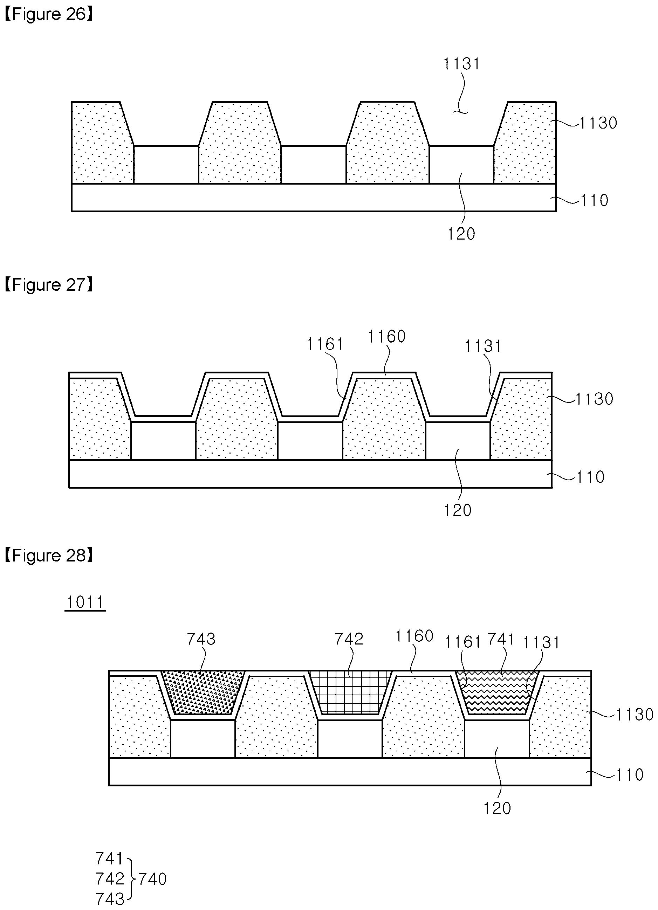

FIG. 26 to FIG. 28 are views illustrating a method of manufacturing the light emitting module according to the eleventh embodiment of the present invention.

Referring to FIG. 26, the molding portion 1130 having the openings 1131 is formed on the circuit board 110.

For description of a method of forming the molding portion 1130 having a plurality of openings according to this embodiment, refer to the method of forming the molding portion 730 having the openings 731 in the light emitting module 1007 (see FIG. 11 to FIG. 14) according to the seventh embodiment.

When the molding portion 1130 is formed on the circuit board 110, the light emitting devices 120 may be disposed in the openings 1131 of the molding portion 1130, respectively.

Referring to FIG. 27, the electrode 1160 may be formed on the molding portion 1130 and the plurality of light emitting devices 120.

According to this embodiment, the electrode 1160 may be formed along a surface of the molding portion 1130. That is, the electrode 1160 may be formed to cover an upper surface of the molding portion 1130 and an inner wall of the molding portion forming the openings 1131 of the molding portion 1130. In addition, the electrode 1160 may cover the upper surfaces of the light emitting devices 120 exposed through the openings 1131 of the molding portion 1130. Since the electrode 1160 is formed along the surface of the molding portion 1130, the electrode 1160 may protrude downwards in the openings 1131 of the molding portion 1130. Here, the recesses 1161 where the height of the electrode 1160 is lower than the height of the electrode disposed on the upper surface of the molding portion 1130 may be formed in the protruding portions of the electrode 1160 disposed in the openings 1131 of the molding portion 1130.

The electrode 1160 may be electrically connected to a semiconductor layer exposed on the upper surfaces of the light emitting devices 120 through the openings of the molding portion 1130.

Referring to FIG. 28, the wavelength conversion portions 740 may be formed.

The wavelength conversion portions 740 may be formed to fill the recesses 1161 of the electrode 1160.

Accordingly, the light emitting module 1011 according to the eleventh embodiment may have a structure in which the light emitting device 120, the electrode 1160 and the wavelength conversion portion 740 are sequentially stacked in each of the openings 1131 of the molding portion 1130.

Referring to FIG. 28, in the light emitting module 1011 according to the eleventh embodiment, the molding portion 1130 has a flat structure. Alternatively, the molding portion 1130 may have a convex or concave upper surface.

According to this embodiment, the light emitting module may include a light emitting package.

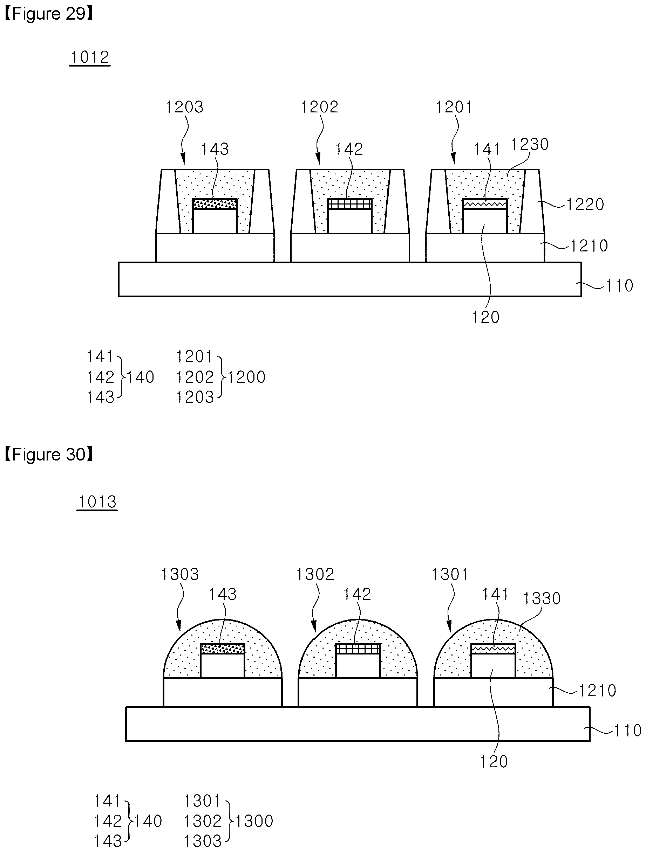

FIG. 29 is a sectional view according to a twelfth embodiment of the present invention.

Referring to FIG. 29, the light emitting module 1012 may include a circuit board 110 and a plurality of light emitting packages 1200 disposed on the circuit board 110. The plurality of light emitting packages 1200 mounted on the circuit board 110 may include first to third light emitting packages 1201, 1202, 1203.

Each of the light emitting packages 1200 may include a support substrate 1210, a light emitting device 120, a wavelength conversion portion 140, a dam 1220, and a molding portion 1230.

The support substrate 1210 may include a circuit pattern electrically connected to the light emitting device 120 and the circuit board 110. The light emitting device 120 and the circuit board 110 may be electrically connected to each other through the support substrate 1210.

The light emitting device 120 may be mounted on the support substrate 1210. In addition, the wavelength conversion portion 140 may be formed on the light emitting device 120.

The first light emitting package 1201 may include a first wavelength conversion portion 141, the second light emitting package 1202 may include a second wavelength conversion portion 142, and the third light emitting package 1203 may include a third wavelength conversion portion 143.

The dam 1220 may be formed on the support substrate 1210 to surround a side surface of the light emitting device 120. Here, an inner wall of the dam 1220 may be spaced apart from the light emitting device 120. The dam 1220 may reflect light emitted from the light emitting device 120 and the wavelength conversion portion 140. For example, the dam 1220 may be formed of a light reflective material. Alternatively, the dam 1220 may be formed by coating the light reflective material on an inner wall facing the light emitting device 120 and the wavelength conversion portion 140.

In this embodiment, the dam 1220 may be formed in a structure in which a diameter of the dam 1220 gradually decreases upwards from the bottom. However, it should be understood that the structure of the dam 1220 is not limited thereto. Alternatively, the dam 1220 may be formed in various structures capable of reflecting light, which travels from the light emitting device 120 and the wavelength conversion portion 140 in a lateral direction, to be directed upwards.

The molding portion 1230 may cover the plurality of light emitting devices 120 by filling an inner space of the dam 1220.

FIG. 30 is a sectional view of a light emitting package according to a thirteenth embodiment of the present invention.

Referring to FIG. 30, the light emitting module 1013 according to the thirteenth embodiment may include a circuit board 110 and a plurality of light emitting packages 1300 disposed on the circuit board 110.

Each of the light emitting packages 1300 may include a support substrate 1210, a plurality of light emitting devices 120, a wavelength conversion portion 140, and a molding portion 1330.

According to this embodiment, the light emitting packages 1300 do not include the dam 1220 (see FIG. 29) and the molding portion 1330 has a different structure than that of the light emitting package 1300.

In addition, the light emitting packages 1300 may include first to third light emitting packages 1301, 1302, 1303. The first light emitting package 1301 may include a first wavelength conversion portion 141, the second light emitting package 1302 may include a second wavelength conversion portion 142, and the third light emitting package 1303 may include a third wavelength conversion portion 143.

Referring to FIG. 30, the molding portion 1330 according to this embodiment has a curved outer surface. For example, the molding portion 1330 may have a dome shape.

The dome-shaped molding portion 1330 may adjust a beam angle of light emitted from the light emitting packages 1300 according to the radius of curvature and structure of the outer surface thereof.

Referring to FIG. 29 and FIG. 30, in the light emitting modules 1013 according to the twelfth and thirteenth embodiments, each of the plurality of light emitting packages 1200, 1300 may include a single light emitting device 120. Here, the plurality of light emitting packages 1200, 1300 may be individually operated.

Although each of the light emitting packages 1200, 1300 includes a single light emitting device 120, it should be understood that other implementations are possible. Each of the light emitting packages 1200, 1300 may include a plurality of light emitting devices 120 and a plurality of wavelength conversion portions 140.

For example, the plurality of wavelength conversion portions 140 included in one light emitting package 1200 or 1300 may include the same wavelength conversion material. That is, each of the light emitting packages 1200, 1300 may emit light of only one color. Here, the plurality of light emitting devices 120 included in each of the light emitting packages 1200, 1300 may operate simultaneously.

Alternatively, each of the light emitting packages 1200, 1300 may include a plurality of light emitting devices 120 and wavelength conversion portions 140 containing different materials. For example, each of the light emitting packages 1200, 1300 may include a first wavelength conversion portion 141, a second wavelength conversion portion 142, and a third wavelength conversion portion 143. Accordingly, each of the light emitting packages 1200 and 1300 may emit light having various colors. Here, the plurality of light emitting devices 120 in each of the light emitting packages 1200, 1300 may be individually operated.

Here, each of the light emitting packages 1200, 1300 according to these embodiments may act as a pixel of the light emitting modules 1012, 1013.

In addition, although each of the light emitting packages 1200, 1300 according to these embodiments includes the support substrate 1210, the support substrate 1210 may be omitted. In this case, the light emitting packages 1200, 1300 not including the support substrate 1210 may be directly mounted on the circuit board 110 and the light emitting devices 120 may be directly electrically connected to the circuit board 110.

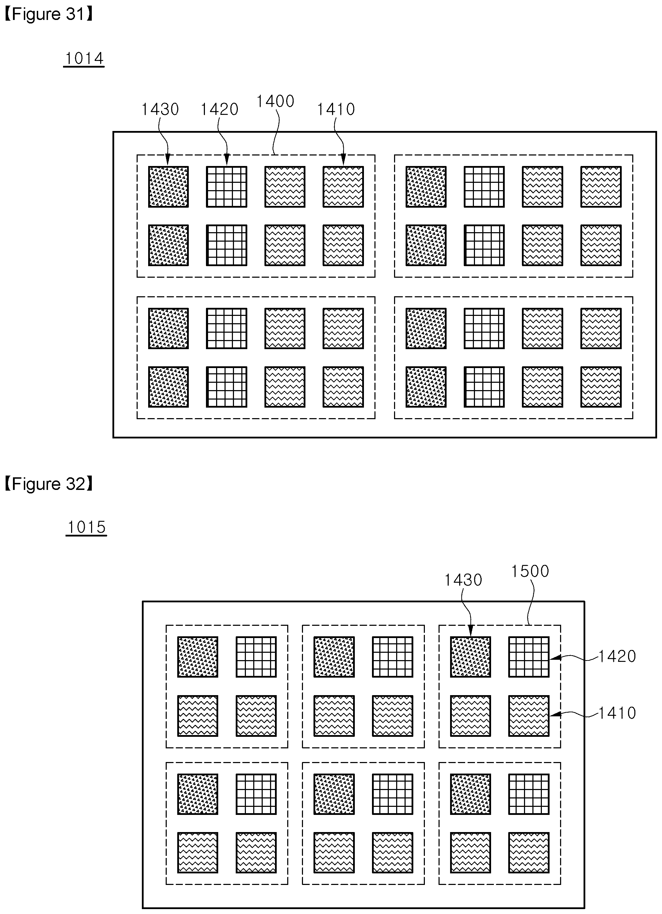

FIG. 31 to FIG. 34 are views illustrating various embodiments of pixel arrangement of the light emitting modules according to the embodiments of the present invention.

According to this embodiment, a light emitting module 1014; 1015; 1016; 1017 may include a plurality of pixels 1400; 1500; 1600; 1700. In the light emitting module 1014; 1015; 1016; 1017, the pixels 1400; 1500; 1600; 1700 may be the minimum unit capable of realizing light of various colors corresponding to red light, green light, blue light and combinations thereof.

Each of the pixels 1400; 1500; 1600; 1700 includes a plurality of light emitting portions. Here, each of the light emitting portions may be a light emitting region including the light emitting device and the wavelength conversion portion described in the above embodiments and in the following embodiments. For example, the light emitting portion refers to a region provided with one light emitting device and a wavelength conversion portion disposed on the light emitting device to emit light having a predetermined color.

In this embodiment, each of the pixels 1400; 1500; 1600; 1700 may include a first light emitting portion 1410, a second light emitting portion 1420, and a third light emitting portion 1430. Here, the first light emitting portion 1410 may emit red light, the second light emitting portion 1420 may emit green light, and the third light emitting portion 1430 may emit blue light.

The configuration and arrangement of the pixels 1400; 1500; 1600; 1700 of the light emitting modules 1014; 1015; 1016; 1017 according to the embodiments of the present invention may be changed according to the configuration and arrangement of the wavelength conversion portions.

FIG. 31 is a view of a first embodiment of a pixel arrangement of a light emitting module according to the present invention.

According to this embodiment, each of the pixels 1400 of the light emitting module 1401 may include a plurality of first light emitting portions 1410, a plurality of second light emitting portions 1420, and a plurality of third light emitting portions 1430. In this embodiment, each of the pixels 1400 may include a greater number of first light emitting portions 1410 emitting red light than the second light emitting portions 1420 and the third light emitting portions 1430.

FIG. 32 is a view of a second embodiment of the pixel arrangement of the light emitting module according to the present invention.

According to this embodiment, the pixels 1500 of the light emitting module 1015 may include first light emitting portions 1410, second light emitting portions 1420, and third light emitting portions 1430. In this embodiment, the pixels 1500 may include a greater number of first light emitting portions 1410 emitting red light than the second light emitting portions 1420 and the third light emitting portions 1430.

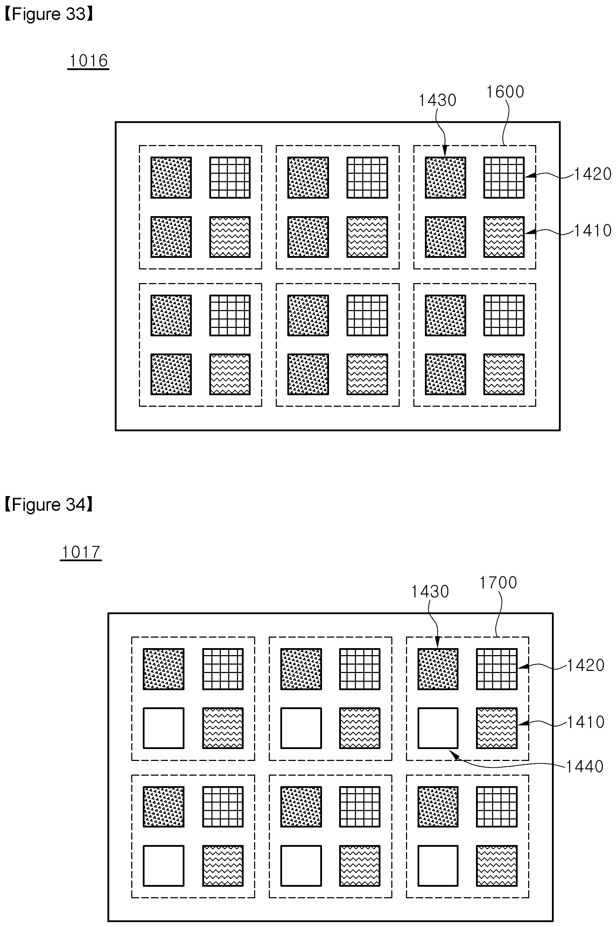

FIG. 33 is a view of a third embodiment of the pixel arrangement of the light emitting module according to the present invention.

According to this embodiment, each of the pixels 1600 of the light emitting module 1016 may include a greater number of second light emitting portions 1420 emitting green light than the first light emitting portions 1410 and the second light emitting portions 1420.

In the first embodiment, the pixels 1400 (see FIG. 31) include a greater number of first light emitting portions 1410 emitting red light than other light emitting portions 1420, 1430, and in the second embodiment, the pixels 1500 (see FIG. 32) include a greater number of second light emitting portions 1420 emitting green light than other light emitting portions 1410, 1430. However, it should be understood that the arrangement and structure of the pixels are not limited thereto.

As shown in FIG. 33, the pixels 1600 may include a greater number of third light emitting portions 1430 emitting blue light than other light emitting portions 1410, 1420.

As in this embodiment, the pixels 1600 may be configured to include a greater number of light emitting portions emitting a relatively small quantity of light than other light emitting portions among the light emitting portions emitting different colors. Accordingly, the pixels 1600 may uniformly emit light having different colors while improving characteristics, such as color reproducibility and color sharpness, of a display apparatus provided with the light emitting module 1001 according to this embodiment.

FIG. 34 is a view of a fourth embodiment of the pixel arrangement of the light emitting module according to the present invention.

According to this embodiment, the pixels 1700 of the light emitting module 1017 may include the same number of first light emitting portions 1410, the same number of second light emitting portions 1420, the same number of third light emitting portions 1430, and the same number of dummy portions 1440. For example, each of the pixels 1700 may include one first light emitting portion 1410, one second light emitting portion 1420, one third light emitting portion 1430, and one dummy portion 1440.

According to this embodiment, the dummy portion 440 is a light emitting portion not formed with the wavelength conversion portion. For example, the dummy portion 440 may include a light emitting device and an empty space, in which the wavelength conversion portion is not disposed, on the light emitting device. Alternatively, the dummy portion 440 may be formed with a light transmissive or light reflective molding portion on the light emitting device instead of the wavelength conversion portion.

The light emitting device included in the dummy portion 440 may be the same light emitting device as the first to third light emitting portions 1410, 1420, 1430.

According to this embodiment, the light emitting device of the dummy portion 440 is not operated in normal operation of all of the light emitting portions included in the pixel 1700. That is, when the pixel 1700 is normal, the light emitting module 1017 does not supply electricity to the light emitting device in the dummy portion 440 and the light emitting device in the dummy portion 440 does not emit light.

The pixels 1700 can suffer from a defect in which one of the first to third light emitting portions 1410, 1420, 1430 does not operate or emits a reduced quantity of light. In this case, the dummy portion 440 may be further provided with a wavelength conversion portion corresponding to a defective light emitting portion. That is, the same wavelength conversion portion as the defective light emitting portion or a wavelength conversion portion emitting the same color as the defective light emitting portion may be disposed on the light emitting device of the dummy portion 440.

In addition, when the pixel 1700 has a defect, the light emitting module 1001 may supply electricity to the light emitting device in the dummy portion 440 such that light is emitted from the dummy portion 440 of the defective pixel 1700.

The pixels 1700 according to this embodiment may emit light having the same color as the defective light emitting portion simply by adding a wavelength conversion portion, which corresponds to the wavelength conversion portion of the defective light emitting portion, to the dummy portion 440. Accordingly, the pixels 1700 according to this embodiment may operate normally even if the light emitting portion is defective, by complementing or replacing the defective light emitting portion.

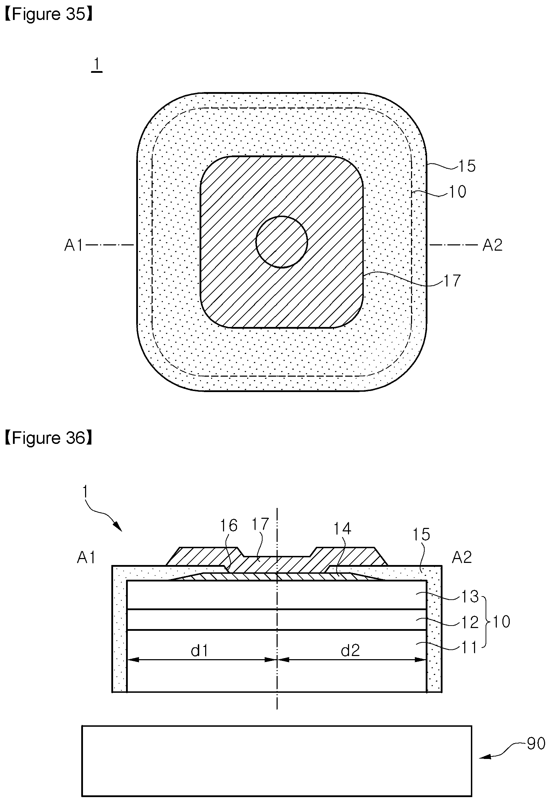

FIG. 35 and FIG. 36 are views of a light emitting device according to a first embodiment of the present invention.

FIG. 35 is a plan view of the light emitting device according to the first embodiment of the present invention. FIG. 36 is a sectional view of the light emitting device according to the first embodiment of the present invention.

The light emitting device 1 according to the first embodiment is a vertical type light emitting diode.

Referring to FIG. 35, the light emitting device 1 according to this embodiment may have a structure in which both sides are parallel and linear, and corners are curved. However, it should be understood that other implementations are possible. Alternatively, both side surfaces of the light emitting device 1 may be inclined at a predetermined angle. Alternatively, both side surfaces of the light emitting device 1 may be inclined such that imaginary lines extending from both sides meet at a certain point.

Referring to FIG. 35 and FIG. 36, the light emitting device 1 according to this embodiment may include a structure in which a light emitting structure 10, a material layer 14, an insulating layer 15, and an electrode 17 are sequentially stacked.

The light emitting structure 10 may have a structure in which a first semiconductor layer 11, an active layer 12, and a second semiconductor layer 13 are sequentially stacked. In addition, the first semiconductor layer 11, the active layer 12 and the second semiconductor layer 13 may be nitride semiconductor layers sequentially grown on the growth substrate 90. The type of light generated from the light emitting structure 10 may vary according to the compositions of the first semiconductor layer 11, the second semiconductor layer 13 and the active layer 12.

The first semiconductor layer 11 may be formed of a compound semiconductor, such as a group III-V compound semiconductor or a group II-VI compound semiconductor. The first semiconductor layer 11 may be a p-type semiconductor layer doped with p-type dopants. For example, the first semiconductor layer 11 may be formed of AlGaN or GaN doped with p-type dopants.

In addition, the second semiconductor layer 13 may be formed of a compound semiconductor, such as a group III-V compound semiconductor or a group II-VI compound semiconductor. The second semiconductor layer 13 may be an n-type semiconductor layer doped with n-type dopants.

For example, the second semiconductor layer 13 may be formed of AlGaN doped with n-type dopants. Here, an Al composition ratio may be changed according to the wavelength band of light emitted from the active layer 12. In addition, the Al composition ratio of the second semiconductor layer 13 may be about 10% or more. When the Al composition ratio is less than about 10%, the second semiconductor layer 13 can absorb light generated from the active layer 12.

In addition, the second semiconductor layer 13 having an Al composition ratio of about 10% or more may prevent light absorption and may reflect light traveling toward the second semiconductor layer 13 such that the light is directed toward the first semiconductor layer 11. As a result, light emitting device 1 can achieve improvement in luminous efficacy.

Although the first semiconductor layer 11 is illustrated as a p-type semiconductor layer and the second semiconductor layer 13 is illustrated as an n-type semiconductor layer in this embodiment, the first semiconductor layer 11 may be an n-type semiconductor layer and the second semiconductor layer 13 may be a p-type semiconductor layer.

The active layer 12 may be formed between the first semiconductor layer 11 and the second semiconductor layer 13.

The active layer 12 is a layer in which electrons injected through the first semiconductor layer 11 recombine with holes injected through the second semiconductor layer 13, and may generate light through recombination of electrons and holes. Alternatively, the active layer 12 may generate light through recombination of holes injected through the first semiconductor layer 11 and electrons injected through the second semiconductor layer 13.

The active layer 12 may have a single well structure, a multi-well structure, a single quantum well structure, a multi-quantum well (MQW) structure, a quantum-dot structure, or a quantum-wire structure. In addition, the active layer 12 may be composed of at least one selected from among InGaN, AlGaN, and GaN. However, it should be understood that the composition of the active layer 12 is not limited thereto.

In this embodiment, the active layer 12 may generate UV light. For example, the active layer 12 may generate UV light having a peak wavelength in the wavelength range of about 365 nm to about 410 nm. Furthermore, light generated from the active layer 12 may be UV light having a peak wavelength in the wavelength range of about 370 nm to about 380 nm.

A conductive material layer 14 may be formed on the light emitting structure 10. That is, the conductive material layer 14 may be formed to cover at least part of an upper surface of the second semiconductor layer 13. Accordingly, the material layer 14 may be electrically connected to the second semiconductor layer 13 of the light emitting structure 10. The material layer 14 may be formed of a light reflective material or a light transmissive material.

According to one embodiment, the material layer 14 may be formed of a light reflective material. For example, the material layer 14 may include a metal layer reflecting light and/or a Bragg distributed reflector. Here, the material layer 14 may reflect light having passed through the second semiconductor layer 13 toward the first semiconductor layer 11. Accordingly, the material layer 14 formed of the light reflective material can improve luminous efficacy of the light emitting device 1.

According to another embodiment, the material layer 14 may be formed of a light transmissive material. The light emitting device 1 including the material layer 14 formed of the light transmissive material may be applied to a light emitting module, which will be mounted on a transparent display apparatus. Here, the circuit board of the light emitting module may also be formed of the light transmissive material. When the light emitting module or the display apparatus is turned off, the display apparatus may act as a transparent glass.

The insulating layer 15 may be formed on the material layer 14. The insulating layer 15 may be formed to cover not only the material layer 14 but also the upper and side surfaces of the light emitting structure 10. The insulating layer 15 may be formed of any of insulating materials typically used for light emitting diodes. For example, the insulating layer 15 may be formed of SiO₂.

The insulating layer 15 may include an opening 16 having a through-hole structure. The opening 16 of the insulating layer 15 may be disposed on the material layer 14. The opening 16 of the insulating layer 15 may be placed on or near a central vertical line with reference to the width of the light emitting structure 10. For example, the opening 16 of the insulating layer 15 may have a difference of about 20% or less between a distance d1 from the central axis of the opening 16 to one side of the light emitting structure 10 and a distance d2 from the central axis thereof to the other side thereof. Furthermore, d1 may be equal to d2.

The electrode 17 made of a conductive material may be formed on the insulating layer 15. The electrode 17 may be formed to cover at least part of an upper surface of the insulating layer 15 while contacting the material layer 14 through the opening 16 of the insulating layer 15. Accordingly, the electrode 17 may be electrically connected to the second semiconductor layer 13 of the light emitting structure 10 through the material layer 14.

When the electrode 17 is formed along the surface of the insulating layer 15, the electrode 17 may include a concave structure in a region formed with the opening 16 of the insulating layer 15, as shown in FIG. 36. That is, it can be seen that the opening 16 of the insulating layer 15 is placed under the concave portion of the electrode 17.

When a plurality of light emitting devices 1 is mounted on the circuit board of the light emitting module, it is easy for the plurality of light emitting devices 1 to be placed at the concave portion of the electrode 17 or to be placed collinear with the opening 16 of the insulating layer 15.

When the light emitting device 1 is mounted on the circuit board of the light emitting module, the light emitting device 1 may be disposed such that the electrode 17 faces the circuit board. Accordingly, the electrode 17 may be electrically connected to the circuit pattern on the circuit board directly or through a conductive bonding material.

The light emitting device 1 according to this embodiment may have a cross-sectional area of about 30 µm x 30 µm or less. Alternatively, the light emitting device 1 may have a cross-sectional area of about 10 µm x 10 µm or less.

The light emitting device 1 according to this embodiment may be formed on the growth substrate 90 having a flat upper surface, which in turn is removed from the light emitting device. Accordingly, since the light emitting device 1 does not include the growth substrate 90, a lower surface of the first semiconductor layer 11 is exposed, as shown in FIG. 36. The exposed lower surface of the first semiconductor layer 11 may be flat corresponding to the upper surface of the growth substrate 90. Here, the lower surface of the first semiconductor layer 11 may face upwards when the light emitting device 1 is mounted on the circuit board of the light emitting module.

The light emitting device 1 according to this embodiment may emit light towards a side surface and a lower surface of the first semiconductor layer 11. Thereamong, the lower surface of the first semiconductor layer 11 may become a main light exit surface through which light generated in the light emitting device 1 is mainly emitted to the outside.

In addition, as the growth substrate 90 is removed from the light emitting device 1 according to this embodiment, the lower surface of the first semiconductor layer 11 facing upwards may contact the electrode 17 to allow electrical connection between the first semiconductor layer 11 and the electrode 17 in manufacture of the light emitting module 1001.

Further, in the light emitting device 1 according to this embodiment, the lower surface of the first semiconductor layer 11 may have a flat structure, whereby the electrode 17 can be stably formed on the lower surface of the first semiconductor layer 11 while stably contacting the lower surface thereof.

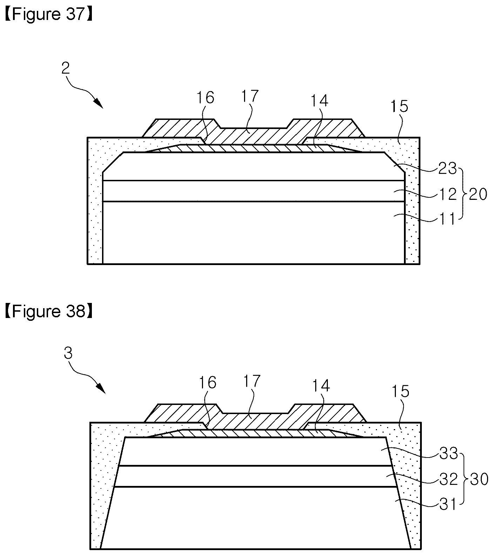

FIG. 37 is a sectional view of a light emitting device according to a second embodiment of the present invention.

In addition, FIG. 38 is a sectional view of a light emitting device according to a third embodiment of the present invention.

Both the light emitting device 2 according to the second embodiment and the light emitting device 3 according to the third embodiment are vertical type light emitting diodes. The light emitting devices 2, 3 according to the second and third embodiments have the same structure as the light emitting device 1 (see FIG. 35 to FIG. 36) according to the first embodiment excluding light emitting structures 10, 20, 30.

In the light emitting devices 2, 3 according to the second and third embodiments, the light emitting structures 20, 30 have a structure in which at least part of each of the light emitting structures has a width gradually decreasing in an upward direction.

Referring to FIG. 37, the light emitting device 2 according to the second embodiment has a structure in which a portion of the light emitting structure 20 has a gradually decreasing width in the upward direction. For example, the structure having a gradually decreasing width may be formed at an upper portion of the light emitting structure 20 with reference to the center of the thickness of the light emitting structure 20. Furthermore, a corner connecting an upper surface of the second semiconductor layer 23 to a side surface thereof may be an inclined surface. By the inclined surface, the light emitting structure 20 may have the structure having a gradually decreasing width in the upward direction.

According to this embodiment, an upper surface of each of the second semiconductor layers 23, 33 is coved by the material layer 14. Accordingly, light generated in each of the active layers 12, 32 and traveling upwards may be reflected by the material layer 14. Light traveling towards an outer periphery of the upper surface of each of the second semiconductor layers 23, 33 including a corner, which is not covered by the material layer 14, may be reflected by the inclined surface to be directed towards the first semiconductor layers 11, 31.

Accordingly, in the light emitting device 2 according to the second embodiment, light traveling towards the second semiconductor layer 23 may be reflected by the material layer 14 and the inclined surface of the second semiconductor layer 23 to be directed towards the first semiconductor layer 11, thereby improving luminous efficacy.

Alternatively, the light emitting device 2 according to the second embodiment may have a structure in which the entire upper surface of the light emitting structure 20 inside the inclined surface of the light emitting structure 20 is covered by the material layer 14.

Further, in the light emitting device 2 according to the second embodiment, the upper surface of the light emitting structure 20 may be connected to the inclined surface at an obtuse angle. Accordingly, the light emitting device 2 can more efficiently prevent current crowding at the corner thereof than a structure in which the upper surface of the light emitting structure 20 is connected to the side surface thereof at a right angle.

Referring to FIG. 37, the light emitting device 3 according to the third embodiment has a structure in which the entirety of the light emitting structure 30 has a width gradually increasing upwards. For example, the light emitting structure 30 may have an inclined side surface. Accordingly, in the light emitting device 3 according to the third embodiment, the side surfaces of all of the first semiconductor layer 31, the active layer 32 and the second semiconductor layer 33 are inclined surfaces.

Accordingly, the light emitting structure 30 according to the third embodiment allows not only light traveling towards the upper surface of the second semiconductor layer 33 but also light traveling towards the side surface of the light emitting structure 30 to be directed towards a lower surface of the first semiconductor layer 31, thereby improving luminous efficacy.

In addition, since the light emitting device 3 according to the third embodiment has a structure in which the upper surface of the light emitting structure 30 is connected to the side surface thereof at an obtuse angle, the light emitting device 3 can more efficiently prevent current crowding at the corner thereof than the structure in which the upper surface of the light emitting structure is connected to the side surface thereof at a right angle.

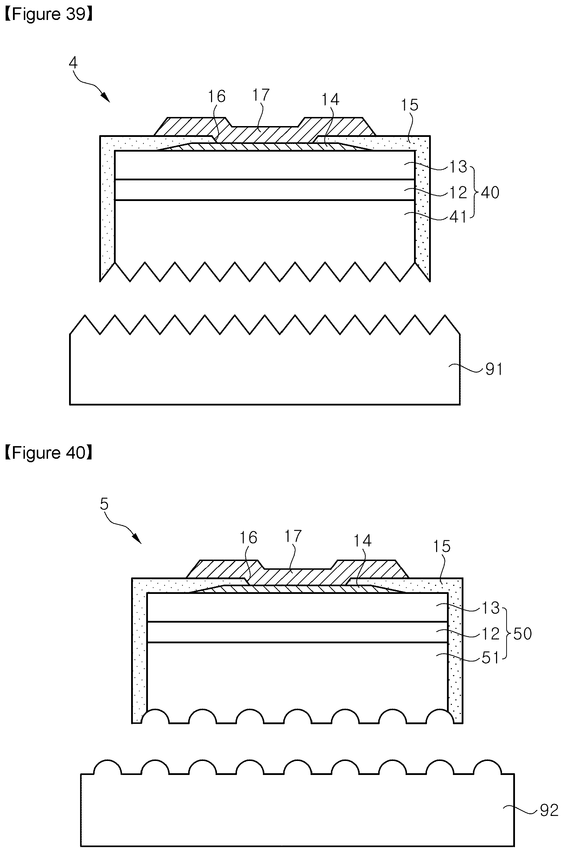

FIG. 39 is a sectional view of a light emitting device according to a fourth embodiment of the present invention.

In addition, FIG. 40 is a sectional view of a light emitting device according to a fifth embodiment of the present invention.

Referring to FIG. 39 and FIG. 40, the light emitting devices 4, 5 according to the fourth and fifth embodiments may include lower surfaces having a convex-concave structure. That is, the light emitting devices 4, 5 according to the fourth and fifth embodiments have roughness on lower surfaces of first semiconductor layers 41, 51 of light emitting structures 40, 50.

The convex-concave structure of the lower surfaces of the light emitting devices 4, 5 may be formed by structures of growth substrates 91, 92.

Referring to FIG. 39, the light emitting device 4 according to the fourth embodiment may be formed on a growth substrate 91 having a triangular pyramid roughness structure. Then, when the growth substrate 91 is removed from the light emitting device 4, the lower surface of the light emitting device 4 may include a triangular pyramid roughness structure corresponding to an upper surface of the growth substrate 91. However, it should be understood that other implementations are possible. After removal of the growth substrate 91, the triangular pyramid roughness structure may be formed on the light emitting device 5 through a separate etching process.

Referring to FIG. 40, the light emitting device 5 according to the fifth embodiment may be formed on the growth substrate 92 having a hemispherical roughness structure. Then, when the growth substrate 92 is removed from the light emitting device 5, the lower surface of the light emitting device 5 may include a hemispherical roughness structure corresponding to the upper surface of the growth substrate 92. However, it should be understood that other implementations are possible. Alternatively, a hemispherical roughness structure may be formed on the light emitting device 5 through a separate etching process after removal of the growth substrate 92.

The growth substrates 91, 92 may be removed from the light emitting devices 4, 5 in various ways. For example, the growth substrates 91, 92 may be removed from the light emitting devices 4, 5 by laser lift-off. A growth substrate on which roughness is not formed may also be removed from the light emitting device by a laser lift-off method.

In the light emitting devices 4, 5 according to the fourth and fifth embodiment, the lower surfaces of the first semiconductor layers 41, 51 corresponding to the light exit surface may also include a roughness structure. The roughness structure formed on the light exit surface of each of the light emitting devices 4, 5 can prevent light from reentering the light emitting devices 4, 5 through specular reflection of light on the light exit surface, thereby improving luminous efficacy of the light emitting devices 4, 5.

Although the triangular pyramid and hemispherical structures have been described as examples of the roughness structure in this embodiment, the roughness structure may be changed in various ways. The roughness structure may have a uniform pattern shape or a non-uniform shape.

The various structures of the light emitting devices 4, 5 described in FIG. 37 to FIG. 40 may also be applied to a light emitting device having an n-type semiconductor layer disposed to face the light emission surface, which is described below.

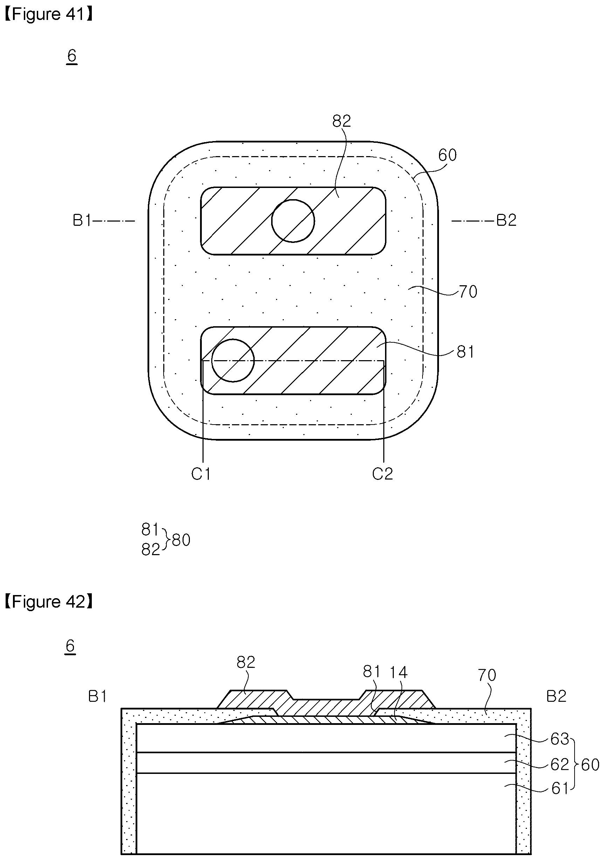

FIG. 41 to FIG. 44 are views of a light emitting device according to a sixth embodiment of the present invention.

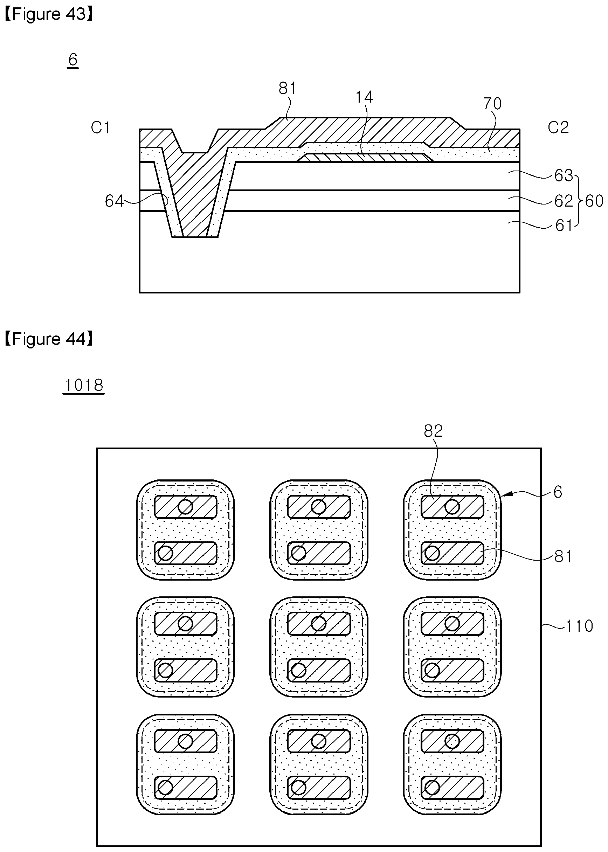

FIG. 41 is a plan view of the light emitting device according to the sixth embodiment of the present invention. FIG. 42 is a sectional view of the light emitting device according to the sixth embodiment of the present invention. FIG. 43 is another sectional view of the light emitting device according to the sixth embodiment of the present invention. In addition, FIG. 44 is an exemplary view of the light emitting devices according to the sixth embodiment of the present invention on a growth substrate.

The light emitting device 6 according to the sixth embodiment is a light emitting diode in which an n-type semiconductor layer is disposed to face the light emission surface.

Referring to FIG. 41, the light emitting device 6 according to this embodiment may have a structure in which both side surfaces are parallel and linear, and corners are curved surfaces.

The light emitting device 6 according to this embodiment may include a light emitting structure 60, an insulating layer 70, a material layer 14, and an electrode 80.

Materials for the light emitting structure 60, the insulating layer 70, the material layer 14 and the electrode 80 of the light emitting device 6 according to this embodiment may be the same as those of the light emitting device 1 (see FIG. 35 and FIG. 36) according to the first embodiment. Thus, the following description will focus on a difference between the light emitting device 6 according to this embodiment and the light emitting device 1 (see FIG. 35 and FIG. 36) according to the first embodiment.

The light emitting structure 60 may include a first semiconductor layer 61, a second semiconductor layer 63, and an active layer 62 formed between the first semiconductor layer 61 and the second semiconductor layer 63.

Referring to FIG. 42 and FIG. 43, the insulating layer 70 may be formed to cover the light emitting structure 60 and the material layer 14.

Referring to FIG. 43, the light emitting structure 60 may be formed with a first opening 64 that exposes the first semiconductor layer 61. The first opening 64 may be formed to expose the first semiconductor layer 61 by partially removing the second semiconductor layer 63 and the active layer 62 to pass through the second semiconductor layer 63 and the active layer 62. That is, in the light emitting structure 60, a bottom surface of the first opening 64 may constitute the first semiconductor layer 61. Here, the first semiconductor layer 61 may also be partially removed according to the depth of the first opening 64 of the light emitting structure 60.

The active layer 62 and the second semiconductor layer 63 may have a mesa structure by the first opening 64 of the light emitting structure 60.

In addition, the insulating layer 70 may be formed to cover the second semiconductor layer 63 and the material layer 14 formed on an upper surface of the second semiconductor layer 63. Here, the insulating layer 70 may be formed to cover an inner wall of the light emitting structure 60, which constitutes the first opening 64 of the light emitting structure 60. That is, the insulating layer 70 may be formed to cover side surfaces of the first semiconductor layer 61, the active layer 62 and the second semiconductor layer 63, which are exposed in the first opening 64 of the light emitting structure 60.

Referring to FIG. 42, the insulating layer 70 may include second openings 81 that expose the material layer 14.

The electrode 80 may include a first electrode 81 and a second electrode 82. The first electrode 81 and the second electrode 82 may be formed to be spaced apart from each other on the insulating layer 70.

Referring to FIG. 43, the first electrode 81 may contact the first semiconductor layer 61 to be electrically connected thereto through the first opening 64 of the light emitting structure 60. Here, the first electrode 81 may be insulated from the active layer 62 and the second semiconductor layer 63 by the insulating layer 70 covering the first opening 64.

Referring to FIG. 42, the second electrode 82 may contact the material layer 14 through the first opening 81 of the insulating layer 70. Accordingly, the second electrode 82 may be electrically connected to the first semiconductor layer 61 through the material layer 14.

Both the first electrode 81 and the second electrode 82 may be formed along the surface of the insulating layer 70. In addition, the first electrode 81 may be formed to fill at least part of the first opening 64 of the light emitting structure 60. Accordingly, the first electrode 81 may have a concave upper surface on the first opening 64 of the light emitting structure 60 and the second electrode 82 may have a concave upper surface on the second opening 81 of the insulating layer 70. That is, it can be seen that a concave portion of the first electrode 81 is a portion where the first electrode 81 contacts the first semiconductor layer 61 and is electrically connected thereto, and a concave portion of the second electrode 82 is a portion where the second electrode 82 is connected to the second semiconductor layer 63.

Referring to FIG. 41, in the light emitting device 6 according to this embodiment, the portion where the first electrode 81 is electrically connected to the first semiconductor layer 61 may be placed near the corner of the light emitting device 6.

The light emitting device 6 according to this embodiment may have a cross-sectional area of about 30 µm x 30 µm or less. Alternatively, the light emitting device 1 may have a cross-sectional area of about 10 µm x 10 µm or less.

Referring to FIG. 44, a plurality of light emitting devices may be formed on the growth substrate.

Here, the plurality of light emitting devices 6 may be formed such that the portions where the first electrodes 81 are electrically connected to the first semiconductor layer 61 are placed on the same vertical and horizontal lines. Further, the plurality of light emitting devices 6 may be formed such that the portions where the second electrodes 82 are electrically connected to the second semiconductor layer 63 are placed on the same vertical and horizontal lines.

With reference to a separation space between the plurality of light emitting devices 6, the first electrode 81 disposed on one light emitting device 6 may be symmetrical to the second electrode 82 disposed on another light emitting device 6 adjacent to the one light emitting device 6. Accordingly, it is possible to achieve uniform supply of electricity between the light emitting devices 6.

An ohmic electrode may be additionally disposed between the semiconductor layer and the first electrode 81 of the light emitting device 6. The ohmic electrode may be biased toward at least one region among quadrants. Further, in the plurality of light emitting devices 6, the ohmic electrodes may be disposed in the same quadrant. Therefore, it is possible to prevent deterioration in uniformity of a screen due to the electrodes in fabrication of modules.

In this way, arrangement of the plurality of light emitting devices 6 on the growth substrate facilitates simultaneous connection of the plurality of light emitting devices 6 to the circuit pattern on the circuit board 110. In addition, the circuit design of the circuit board 110 on which the plurality of light emitting devices 6 is mounted can be simplified.

Herein, various embodiments of the light emitting module and the light emitting package on which micro-LEDs are mounted have been described above. However, it should be understood that not only the micro-LEDs but also light emitting devices having various structures may be mounted on the light emitting module and the light emitting package according to the embodiments of the present invention described above.

Although some embodiments have been described herein with reference to the accompanying drawings, it should be understood that the foregoing embodiments are provided for illustration only and are not to be in any way construed as limiting the technical idea of the present invention. The scope of the present invention should be defined by the appended claims and equivalents thereto.

## Claims

1. A light emitting module comprising:
a circuit board;
a plurality of light emitting devices disposed on the circuit board and emitting UV light;
a plurality of wavelength conversion portions each disposed on a light exit surface of the light emitting device emitting UV light and converting a wavelength of light emitted from the light emitting device; and
a molding portion covering the light emitting devices and the wavelength conversion portions formed on the circuit board,
wherein each of the light emitting devices comprises a first semiconductor layer, a second semiconductor layer, and an active layer disposed between the first semiconductor layer and the second semiconductor layer,
one surface of the first semiconductor layer corresponds to the light exit surface of the light emitting device, and
at least one of the plurality of wavelength conversion portions converts light emitted from the light emitting device into light having a different color than light converted by another wavelength conversion portion.

2. The light emitting module according to claim 1, wherein each of the light emitting devices comprises a first electrode electrically connected to the first semiconductor layer and a second electrode electrically connected to the second semiconductor layer, the first electrode and the second electrode being disposed to face the circuit board.

3. The light emitting module according to claim 2, wherein the first electrode and the second electrode of the light emitting device are electrically connected to the circuit board.

4. The light emitting module according to claim 2, wherein the wavelength conversion portion contacts the first semiconductor layer of the light emitting device.

5. The light emitting module according to claim 1, wherein each of the light emitting devices comprises an electrode electrically connected to the second semiconductor layer, the electrode being disposed to face the circuit board.

6. The light emitting module according to claim 5, further comprising:
an electrode disposed between the light emitting devices and the wavelength conversion portions.

7. The light emitting module according to claim 6, wherein the electrode of the light emitting device is electrically connected to the circuit board and the first semiconductor layer of the light emitting device is electrically connected to the electrode.

8. The light emitting module according to claim 1, wherein the molding portion has a flat upper surface, the upper surface of the molding layer having a periphery flush with a periphery of an upper surface of each of the wavelength conversion portions.

9. The light emitting module according to claim 1, wherein the molding portion has a convex or concave upper surface, the upper surface of the molding layer having a periphery flush with a periphery of an upper surface of each of the wavelength conversion portions.

10. The light emitting module according to claim 1, wherein the molding portion comprises a first molding portion covering side surfaces of the light emitting devices and a second molding portion covering side surfaces of the wavelength conversion portions.

11. The light emitting module according to claim 10, wherein each of the first molding portion and the second molding portion has a flat upper surface,
the upper surface of the first molding portion having a periphery flush with a periphery of an upper surface of each of the light emitting devices,
the upper surface of the second molding portion having a periphery flush with a periphery of an upper surface of each of the wavelength conversion portions.

12. The light emitting module according to claim 10, wherein each of the first molding portion and the second molding portion has a convex or concave upper surface,
the upper surface of the first molding portion having a periphery flush with a periphery of an upper surface of each of the light emitting devices,
the upper surface of the second molding portion having a periphery flush with a periphery of an upper surface of each of the wavelength conversion portions.

13. The light emitting module according to claim 1, wherein the plurality of wavelength conversion portions comprises a first wavelength conversion portion converting the light emitted from the light emitting device into red light, a second wavelength conversion portion converting the light emitted from the light emitting device into green light, and a third wavelength conversion portion converting the light emitted from the light emitting device into blue light.

14. The light emitting module according to claim 13, further comprising:
a light emitting portion including the light emitting device and the wavelength conversion portion,
wherein the light emitting portion comprises a first light emitting portion comprising the first wavelength conversion portion, a second light emitting portion comprising the second wavelength conversion portion, and a third light emitting portion comprising the third wavelength conversion portion.

15. The light emitting module according to claim 14, further comprising:
a dummy portion including the light emitting device and free from the wavelength conversion portion.

16. The light emitting module according to claim 1, wherein the second semiconductor layer of the light emitting device has one surface and the other surface connected to the one surface and perpendicular thereto, and the one surface of the second semiconductor layer faces in an opposite direction to the light exit surface.

17. The light emitting module according to claim 1, wherein the second semiconductor layer of the light emitting device has one surface and the other surface connected to the one surface at an obtuse angle, the one surface of the second semiconductor layer facing in an opposite direction to the light exit surface.

18. The light emitting module according to claim 1, wherein the light exit surface of the light emitting device has a roughness structure.

19. The light emitting module according to claim 1, wherein the light emitting device further comprises a material layer covering at least part of one surface of the second semiconductor layer, the material layer being formed of a light reflective material or a light transmissive layer.

20. The light emitting module according to claim 1, wherein the light emitting device has a cross-sectional area of 30 µm x 30 µm or less.
